# DEMANDE DE BREVET EUROPEEN

(11) **EP 4 756 508 A1**
(43) Date de publication de la demande: **10.06.2026**
(21) Numéro de dépôt: 25221579.3
(22) Date de dépôt: 08.12.2025
(51) Int. Cl.: G02B 6/43, H04B 10/80

(54) **DISPOSITIF PHOTONIQUE COMPRENANT UN INTERCONNECTEUR ÉLECTRO-OPTIQUE À MICRO-TUBE**

(30) Priorité: 09.12.2024 FR 2413677
(71) Demandeur: Commissariat à l'Energie Atomique et aux Energies Alternatives, 75015 Paris (FR)
(72) Inventeur: AIT MANI, Abdenacer, 38054 Grenoble Cedex 09 (FR)
(74) Mandataire: Atout PI Laplace

(57) **Abrégé**

Il est proposé un dispositif photonique (10) comprenant un composant émetteur (100), configuré pour émettre au moins un signal d'émission (S₁) comprenant une composante optique de signal, un composant récepteur (200), et un composant d'interconnexion (300) entre le composant émetteur (100) et le composant récepteur (200), le composant d'interconnexion (300) comprenant au moins un micro-tube (310) adapté pour transmettre la composante optique de signal issu du composant émetteur (100) vers le composant récepteur (200). Un micro-tube (310) comprend une paroi (314) et un milieu interne (312) adapté pour propager la composante optique de signal, entouré par la paroi du micro-tube, la paroi (314) étant adaptée pour séparer le milieu interne (312) et un milieu ambiant (40) dans lequel est plongé le dispositif photonique (10).

## Description

### Domaine technique

La présente invention concerne de manière générale le domaine des interconnexions photoniques, et en particulier un dispositif photonique comprenant un interconnecteur électro-optique obtenu à partir d'au moins un micro-tube adapté pour transmettre au moins une composante optique d'un signal, ainsi qu'un procédé de fabrication d'un tel dispositif.

Les interconnexions photoniques sont communément utilisées dans les applications d'acquisition, de transmission et de traitement de l'information dans des circuits intégrés et circuits intégrés photoniques, de manière à améliorer leur performance et leur packaging.

Dans les systèmes d'interconnexions photoniques existants, il est connu de réaliser des trous dans des substrats communément utilisés en microélectronique. Ces trous, encore appelés vias, peuvent être de type 'TSV' (acronyme pour l'expression anglo-saxonne *'Through Silicon Vias'* signifiant Vias traversant le silicium) ou 'TGV' (acronyme pour l'expression anglo-saxonne *'Through Glass Vias'* signifiant via traversant le verre). Ces trous peuvent être fabriqués de manière à former des guides de lumière associés à des propriétés optiques adaptées à une application spécifique et aux longueurs d'ondes exploitées, tels que décrits dans le brevet US 10197730 B1 ou dans la demande de brevet WO 2019/048653 A1.

Cependant, les solutions d'interconnexions photoniques connues présentent des coûts de fabrication élevés et ne prennent pas en compte la faible tolérance des signaux optiques aux désalignements. C'est particulièrement le cas du dispositif décrit dans l'article "3D optical coupling techniques on polymer waveguides for wafer and board level integration" de S. Lüngen et al., IEEE 67th Electronic Components and Technology Conference (ECTC), Orlando, FL, USA, 2017, pp. 1612-1618, dans lequel les vias sont associés à des miroirs pour diriger la lumière, ce qui rend le dispositif extrêmement complexe d'un point de vue technologique et peu robuste.

Ces solutions peuvent en outre présenter des communications optiques parasites (ou fuites optiques) entre les différents vias d'un même interconnecteur, générant ainsi un effet dit de 'diaphonie' (ou 'cross-talk' selon la terminologie anglo-saxonne).

Le problème relatif aux alignements optiques a été étudié dans l'article "Optical Vertical Interconnect and Integration Based on Silicon Carrier" de F. Liu et al., 13th International Conference on Electronic Packaging Technology & High Density Packaging, Guilin, China, 2012, pp. 97-100, dans lequel l'interconnecteur photonique comprend un réseau de fibres optiques. Cet article propose une approche dans laquelle chaque fibre est insérée dans un via de sorte que les vias ont plus un rôle de « guide mécanique » qu'un rôle de « guide de lumière ». Il en résulte en outre des capacités de miniaturisation du dispositif photonique limitées.

Le problème relatif au cross-talk optique a été abordé dans la demande de brevet US 2020/0235038 A1, dans laquelle la fabrication de l'interconnecteur photonique comprend des opérations de gravures pour former des cavités entre les structures TSV ou TGV de manière à les isoler optiquement entre elles. La fabrication comprend également une opération d'application d'un matériau de scellement des cavités à partir d'une épitaxie de matériau hétérogène nécessitant des températures de recuit élevées. Cependant, de telles solutions mettent en œuvre des procédés de fabrication considérablement complexes, associés à des technologies microélectroniques très couteuses.

Il existe ainsi un besoin pour un interconnecteur optique permettant d'améliorer les performances de transmission de signaux optiques entre un émetteur et un récepteur, en tenant compte notamment de la faible tolérance des photons aux désalignements, ainsi que pour un procédé de fabrication amélioré d'un dispositif photonique résultant.

### Résumé de l'invention

La présente invention vient améliorer la situation en proposant un dispositif photonique comprenant un composant émetteur, configuré pour émettre au moins un signal d'émission comprenant une composante optique de signal, un composant récepteur, et un composant d'interconnexion entre le composant émetteur et le composant récepteur. Le composant d'interconnexion comprend au moins un micro-tube adapté pour transmettre la composante optique de signal issu du composant émetteur vers le composant récepteur, le au moins un micro-tube comprenant une paroi et un milieu interne adapté pour propager la composante optique de signal, entouré par la paroi du micro-tube, la paroi étant adaptée pour séparer le milieu interne et un milieu ambiant dans lequel est plongé le dispositif photonique.

Dans des modes de réalisation, le dispositif photonique peut comprendre au moins un élément de raccord en émission configuré pour raccorder le composant émetteur et une extrémité d'un micro-tube.

Le dispositif photonique peut comprendre au moins un élément de raccord en réception configuré pour raccorder le composant récepteur et une extrémité d'un micro-tube.

Avantageusement, le au moins un signal d'émission peut comprendre en outre une composante électrique de signal, la paroi d'un micro-tube comprenant au moins une partie métallique configurée pour propager la composante électrique de signal issu du composant émetteur vers le composant récepteur.

Selon certains aspects de l'invention, le composant d'interconnexion peut comprendre en outre un substrat intermédiaire comprenant au moins un micro-via en association avec chaque micro-tube, le au moins un micro-via étant agencé pour transmettre la composante optique de signal issu du composant émetteur vers le composant récepteur.

Le au moins un signal d'émission peut comprendre en outre une composante électrique de signal, et avantageusement, le au moins un micro-via peut comprendre une paroi métallique configurée pour propager la composante électrique de signal issu du composant émetteur vers le composant récepteur.

Dans des modes de réalisation, le au moins un micro-tube peut comprendre un matériau de remplissage choisi de manière à optimiser la propagation de la composante optique du signal à transmettre.

Le au moins un micro-via peut comprendre un matériau de remplissage choisi de manière à optimiser la propagation de la composante optique du signal à transmettre.

Les dimensions du composant d'interconnexion peuvent être de l'ordre de quelques micromètres à quelques dizaines de micromètres.

Dans certains modes de réalisation, le composant d'interconnexion peut comprendre en outre un interposeur photonique, le au moins un micro-tube s'étendant longitudinalement entre le composant émetteur et l'interposeur photonique, et/ou entre l'interposeur photonique et le composant récepteur.

La présente invention propose également un procédé pour la fabrication du dispositif photonique. Le procédé comprend les étapes consistant à :
- préparer un composant émetteur apte à émettre au moins un signal d'émission comprenant une composante optique de signal, et préparer un composant récepteur,
- fabriquer un composant d'interconnexion comprenant au moins un micro-tube, et
- assembler le composant d'interconnexion entre le composant émetteur et le composant récepteur ;

Le procédé comprend la fabrication du au moins un micro-tube, un micro-tube étant apte à transmettre ladite composante optique de signal issu du composant émetteur vers le composant récepteur, le au moins un micro-tube comprenant une paroi et un milieu interne apte à propager la composante optique de signal, entourée par la paroi du micro-tube, la paroi séparant le milieu interne et un milieu ambiant dans lequel est plongé le dispositif photonique.

Dans des modes de réalisation, l'étape d'assemblage peut comprendre le raccord du composant émetteur et/ou du composant récepteur, avec une extrémité d'un micro-tube, au moyen d'au moins un élément de raccord en émission et/ou d'au moins un élément de raccord en réception, le raccord comprenant une insertion à froid du au moins un micro-tube du composant d'interconnexion dans le au moins un élément de raccord en émission et/ou en réception.

Avantageusement, l'étape de fabrication du composant d'interconnexion peut comprendre :
- la fourniture d'au moins un substrat support,
- la fabrication du au moins un micro-tube, sur une face de support du substrat support,
- la mise en œuvre d'au moins une gravure du substrat support de façon perpendiculaire pour former au moins un micro-via, à partir d'une face arrière du substrat support jusqu'à la face de support, la au moins une gravure étant effectuée de manière à déboucher sur l'intérieur du au moins un micro-tube.

Le au moins un signal d'émission comprend en outre une composante électrique de signal, et l'étape de fabrication du composant d'interconnexion peut comprendre un dépôt d'une couche métallique sur la paroi d'un micro-tube de manière à ce que la paroi comprend au moins une partie métallique apte à propager la composante électrique de signal issu du composant émetteur vers le composant récepteur.

Les modes de réalisation de l'invention fournissent ainsi un interconnecteur photonique comprenant au moins un micro-tube permettant d'améliorer les performances de transmission de signaux optiques entre un émetteur et un récepteur, via un transport de données à faible perte.

Ils fournissent également une solution d'interconnexions parallèles à double fonction permettant la transmission entre substrats d'informations dites 'électriques' et d'informations dites 'optiques'.

Les modes de réalisation de l'invention fournissent avantageusement une solution abordable en termes de coût, la fabrication et l'assemblage de l'interconnecteur photonique étant particulièrement compatible avec une fabrication à grande échelle, le cout unitaire d'un micro-tube s'en trouvant économiquement bon marché.

La fabrication des matrices de micro-tubes, sur une plateforme microélectronique par exemple, permet de garantir la formation d'objets en grande densité (à très faible pas) et à des dimensions micrométriques, générant in fine des dispositifs photoniques denses et compactes de transmission parallèle de données d'un grand nombre d'informations électro-optiques et sans cross talk.

Les modes de réalisation permettent également de faciliter et d'accélérer le procédé pour la fabrication d'un tel dispositif. L'assemblage par insertion à froid permet également de garantir l'intégrité électronique des composants du dispositif, tout en appliquant un rattrapage des défauts de planéité significatifs entre les composants à assembler. Cet assemblage à froid permet également un alignement précis des composants en regard, en évitant les contraintes liées aux différences de coefficient de dilatation thermique (ou CTE, acronyme pour l'expression anglo-saxonne 'Coefficient of Thermal Expansion') entre différents matériaux formant les composants à assembler. De telles contraintes peuvent être communément importantes dans des procédés de fabrication utilisant des assemblages en température (ou à température élevée).

Les modes de réalisation fournissent avantageusement des dispositifs performants réunissant l'utilisation des micro-tubes et des TSVs, ou permettant le couplage à des réseaux de guides préétablis.

### Description des figures

D'autres caractéristiques, détails et avantages de l'invention ressortiront à la lecture de la description faite en référence aux dessins annexés donnés à titre d'exemple.
[Fig.1] La figure 1 est un schéma représentant un dispositif photonique, selon des modes de réalisation de l'invention.
[Fig.2] La figure 2 montre des schémas 2[a] et 2[b] représentant un composant émissif, selon des modes de réalisation de l'invention.
[Fig.3] La figure 3 montre des schémas 3[a] et 3[b] représentant un composant récepteur, selon des modes de réalisation de l'invention.
[Fig.4] La figure 4 montre des schémas 4[a] et 4[b] représentant un micro-tube d'un composant d'interconnexion, selon des modes de réalisation de l'invention.
[Fig.5] La figure 5 est un schéma représentant un dispositif photonique, selon des modes de réalisation de l'invention.
[Fig.6] La figure 6 est un schéma représentant un dispositif photonique, selon des modes de réalisation de l'invention.
[Fig.7] La figure 7 est un schéma représentant un dispositif photonique, selon des modes de réalisation de l'invention.
[Fig.8] La figure 8 montre des schémas 8[a] et 8[b] représentant un micro-via d'un composant d'interconnexion, selon des modes de réalisation de l'invention.
[Fig.9] La figure 9 est un schéma représentant un dispositif photonique, selon des modes de réalisation de l'invention.
[Fig.10] La figure 10 est un organigramme représentant des étapes d'un procédé de fabrication d'un dispositif photonique, selon des modes de réalisation de l'invention.
[Fig.11] La figure 11 montre des organigrammes 11[a] et 11[b] représentant des sous-étapes du procédé de fabrication d'un dispositif photonique, selon des modes de réalisation de l'invention.
[Fig.12] La figure 12 est un organigramme représentant des sous-étapes du procédé de fabrication d'un dispositif photonique, selon des modes de réalisation de l'invention.
[Fig.13] La figure 13 montre des schémas 13[a] et 13[b] représentant un composant d'interconnexion en cours de fabrication, selon des modes de réalisation de l'invention.
[Fig.14] La figure 14 montre des schémas 14[a] et 14[b] représentant un composant d'interconnexion en cours de fabrication, selon des modes de réalisation de l'invention.
[Fig.15] La figure 15 montre des schémas 15[a] et 15[b] représentant un composant d'interconnexion en cours de fabrication, selon des modes de réalisation de l'invention.
[Fig.16] La figure 16 représente des schémas 16[a] et 16[b] représentant un composant d'interconnexion en cours de fabrication, selon des modes de réalisation de l'invention.

Des références identiques sont utilisées dans les figures pour désigner des éléments identiques ou analogues. Pour des raisons de clarté, les éléments représentés ne sont pas à l'échelle.

Par ailleurs, dans la suite de la description, sauf indication contraire, les termes "sensiblement" et "généralement" signifient "à plus ou moins 10% près".

### Description détaillée

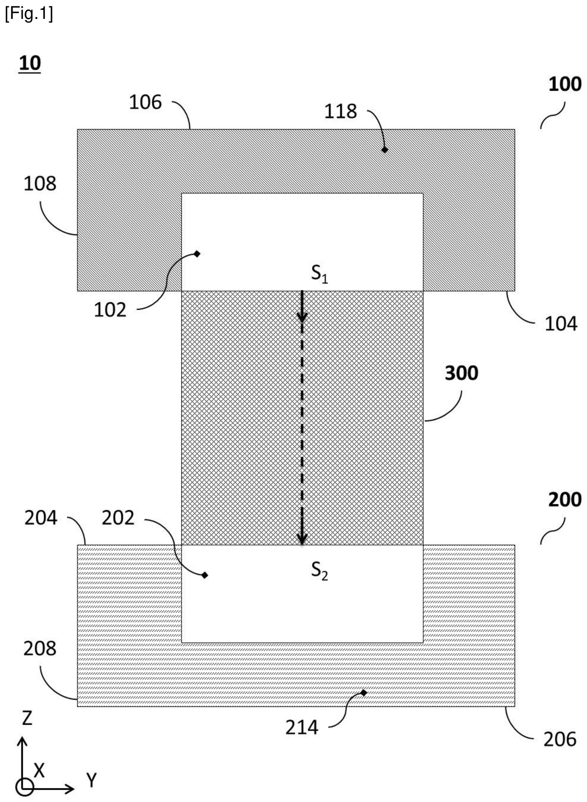

La figure 1 représente schématiquement un dispositif photonique 10 comprenant un composant émetteur 100, un composant récepteur 200 et un composant d'interconnexion 300 entre le composant émetteur 100 et le composant récepteur 200, selon des modes de réalisation de l'invention.

Le dispositif photonique 10 (encore appelé 'dispositif d'interconnexion photonique', 'dispositif de transmission', ou plus simplement 'dispositif') est configuré pour propager des informations en utilisant une transmission de signaux optiques (ou signaux photoniques) d'une source optique vers un récepteur optique. Un tel dispositif peut être implémenté, par exemple et sans limitation, sous la forme d'un dispositif de connexions verticales à transfert de données à débits élevés, ou encore un dispositif planaire émetteur-récepteur (appelé *'transceiver'* en langue anglo-saxonne), permettant la conversion ou la communication de signaux optiques et/ou de signaux électro-optiques. Le dispositif photonique 10 peut être intégré dans un système 1, par exemple à d'autres puces, ou à d'autres éléments de circuits discrets, de circuits intégrés et/ou de dispositifs de traitement de signal. Le système 1, comprenant le dispositif photonique 10, peut être utilisé dans de nombreuses applications, telles que des applications d'acquisition, de transmission et de traitement de l'information. Le système 1 peut être, par exemple et sans limitation, une carte mère utilisée dans des systèmes de télécommunication, dans des systèmes d'imagerie, dans des systèmes industriels (de cybersécurité, ou de fabrication par exemple), dans des systèmes relatifs au domaine bancaire ou fiscal, ou encore dans des systèmes de calculs.

Dans la suite de la description, il sera considéré à titre de simplification que le terme « signal » peut correspondre à un signal optique et/ou à un signal électro-optique.

Un signal électro-optique comprend une composante de signal optique et une composante de signal électrique, de sorte qu'un signal électro-optique porte conjointement des informations dites 'informations optiques' et des informations dites 'informations électriques'. Similairement, un signal optique ne comprend qu'une composante de signal optique, c'est-à-dire qu'un signal optique ne porte que des informations optiques.

En outre, tel qu'utilisé ici, un « signal optique » fait référence à une onde continue ou résulte d'une ou plusieurs impulsions de lumière, non-cohérentes ou cohérentes, provenant d'une source optique (ou source optique émissive), tel qu'un faisceau laser. L'onde électromagnétique (ou faisceau) portant le signal optique est notamment caractérisée par une longueur d'onde *λ* donnée (i.e. relative à une bande fréquentielle ou une bande de fréquences optiques spécifiques). L'onde électromagnétique peut également être caractérisée par une polarisation et une phase donnée. Une bande fréquentielle optique correspond à une plage de fréquences optiques. Une bande fréquentielle optique peut correspondre à des longueurs d'onde dans le domaine de l'infrarouge (IR). Par exemple et sans limitation, une bande fréquentielle optique peut correspondre à des longueurs d'onde égales à 850nm, à 1300nm, ou encore à des longueurs d'onde comprises typiquement entre 1530 nm et 1565 nm (par exemple 1550 nm). Une telle bande de fréquences optiques, définie en proche infrarouge ou en infrarouge moyen, peut être choisie en raison de l'innocuité d'un signal IR pour l'œil et/ou de la facilité de production d'un tel signal. Une bande fréquentielle optique peut également correspondre à des longueurs d'onde dans le domaine du visible. Par exemple et sans limitation, une bande fréquentielle optique peut correspondre à des longueurs d'onde égales à 450nm, 532nm, ou encore 632nm. Une telle bande de fréquences optiques visible peut être choisie dans des cas de transmission d'informations optiques à haut débit.

Le composant émetteur 100 (encore appelé 'composant photonique émetteur", 'composant source', 'substrat émissif', ou encore 'matrice émissive') peut comprendre une ou plusieurs zones d'émission 102 d'un signal noté S₁, selon des modes de réalisation de l'invention. Avantageusement, le composant émetteur 100 peut comprendre une pluralité N de zones d'émission 102-n configurées pour émettre chacune un signal S₁ₙ, « n » étant l'indice correspondant à la n^{ième} zone d'émission du composant émetteur 100. L'indice « n » est donc un entier compris entre 1 et N, la valeur de N étant un entier supérieur ou égal à 1.

Par ailleurs, le composant récepteur 200 (encore appelé 'composant photonique récepteur', 'composant de réception', 'substrat récepteur', ou encore 'matrice réceptrice') peut comprendre une ou plusieurs zones de réception 202 d'un signal noté S₂, selon des modes de réalisation de l'invention. Avantageusement, le composant récepteur 200 peut comprendre une pluralité M de zones de réception 202-m configurés pour recevoir chacune un signal S₁ₘ, « m » étant l'indice correspondant à la m^{ième} zone de réception du composant récepteur 200. L'indice « m » est donc un entier compris entre 1 et M, la valeur de M étant un entier supérieur ou égal à 1.

Dans l'exemple de la figure 1, l'émetteur 100 comprend une zone d'émission 102 et le récepteur 200 comprend une seule zone de réception 202.

Avantageusement, le dispositif de transmission 10 peut par exemple être défini dans un repère (X,Y,Z). Le composant émetteur 100 peut avoir une structure généralement plane, définie dans le plan (X,Y), associé au repère (X,Y,Z) du dispositif, et orthogonale à l'axe Z. Ainsi, le composant émetteur 100 peut s'étendre généralement dans le plan (X,Y). En particulier, le composant émetteur 100 peut comprendre une première face 104 (également appelée 'face d'émission') et une deuxième face 106 opposée à la première face 104. Les première et deuxième faces peuvent être sensiblement parallèles entre elles et définies dans le plan (X,Y) tel que représenté sur la figure 1. Les première et deuxième faces peuvent être reliées par un bord 108, un tel bord étant de faible largeur par rapport à la longueur du composant 100 selon l'axe Y ou X. Les première et deuxième faces du composant émetteur 100 peuvent avoir une forme géométrique quelconque et des dimensions variables dans le plan (X,Y).

Le composant récepteur 200 peut avoir une structure sensiblement plane, et s'étendre généralement dans le plan (X,Y). Le composant récepteur 200 peut comprendre une première face 204 (également appelée 'face de réception') et une deuxième face 206 opposée à la première face 204. Les première et deuxième faces peuvent être sensiblement parallèles entre elles, définies dans le plan (X,Y), et être reliées par un bord 208, un tel bord étant de faible largeur par rapport à la longueur du composant 200 selon l'axe Y ou X. Les première et deuxième faces du composant récepteur 200 peuvent avoir une forme géométrique quelconque et des dimensions variables dans le plan (X,Y).

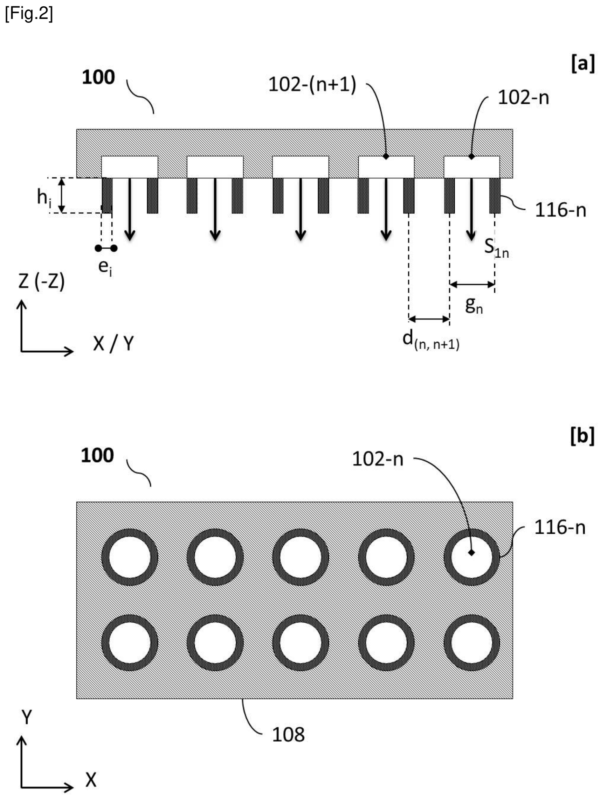

La figure 2 représente deux schémas 2[a] et 2[b], respectivement dans le plan (X,Z) et dans le plan (X,Y), du composant émetteur 100, selon des modes de réalisation de l'invention. Dans les modes de réalisation de la figure 2, le composant émetteur 100 comprend une pluralité de N zones d'émission 102-n. Chaque signal d'émission S₁ₙ provenant d'une zone d'émission 102-n peut être émis selon une direction de propagation de signal généralement parallèle à l'axe normal Z du composant émetteur 100.

La composante optique d'un signal S₁ₙ d'émission, optique ou électro-optique, à transmettre peut être associée à une bande fréquentielle optique d'émission notée *λ*₁ₙ. Dans le cas d'un dispositif de transmission 10 associé à une pluralité de zones d'émission 102-n, les composantes optiques des signaux d'émission S₁ₙ peuvent être associées à une bande fréquentielle unique ou alternativement à plusieurs bandes fréquentielles distinctes entre elles.

Une zone d'émission 102-n peut être distante d'une autre zone d'émission 102-(n+1) d'une distance de séparation, notée d_{(n, n+1)}. Une telle distance de séparation d_{(n, n+1}) (également appelé 'espacement') peut être définie à partir de la géométrie ou de la configuration de répartition des différentes zones et d'au moins une distance minimale de séparation de zones d'émission. Les distances d_{(n, n+1}) peuvent être de l'ordre de quelques micromètres à quelques centaines de micromètres.

En variante, la répartition de zones d'émission peut être déterminée selon un pas de répétition (ou *'pitch'* selon la terminologie anglo-saxonne correspondante) qui peut être défini à partir de la distance de séparation d_{(n, n+1}) par exemple.

Selon des modes de réalisation, la pluralité de zones d'émission 102-n peut être agencée selon une configuration matricielle régulière dans le plan (X,Y) sur la face d'émission 104 du composant émetteur 100 telle que représentée en exemple sur les schémas 2[a] et 2[b] de la figure 2. Cette configuration matricielle régulière peut être définie par une unique distance de séparation d_{(n, n+1}) entre les différentes zones d'émission, considérées deux à deux, du composant émetteur 100. La configuration matricielle régulière de répartition spatiale de zones d'émission 102-n peut avoir n'importe quelle structure géométrique.

Alternativement, les positions des zones d'émission 102-n peuvent être agencées indépendamment les unes par rapport aux autres, selon une répartition de zones d'émission non régulière, pseudo-aléatoire ou encore aléatoire. Par exemple et sans limitation, une répartition non régulière de la pluralité des zones d'émission peut correspondre à un composant d'émission 102 comprenant au moins un premier ensemble de zones d'émission, définies selon un premier espacement de zones d₁₍ₙ, ₙ₊₁₎, et un deuxième ensemble de zones d'émission, définies selon un deuxième espacement de zones d_{2(n, n+1)}. Par exemple, le premier ensemble peut correspondre à des zones d'émission plus denses que le deuxième ensemble, le premier espacement étant alors égal à une valeur inférieure au deuxième espacement. Une telle irrégularité de répartition des zones d'émission dans le plan (X,Y) est appliquée dans le cas de l'utilisation de zones d'émission de différentes natures (c'est-à-dire dans le cas de sources hybrides). Par exemple, le premier ensemble de zones d'émission peut correspondre à des sources issues d'un substrat de pilotage CMOS, tandis que le deuxième ensemble de zones d'émission peut correspondre à des éléments émissifs ajoutés (a posteriori) sur ce même substrat de pilotage pour former le composant d'émission 102. Selon cet exemple, les sources optiques d'une puce CMOS et les éléments émissifs peuvent par exemple être de tailles différentes, et les différents espacements de zones entre les deux ensembles peuvent être déterminés de sorte que la densité des sources du premier ensemble soit équivalente à la densité des sources du deuxième ensemble.

Dans certains modes de réalisation, une zone d'émission 102-n (ou 102) peut comprendre une source d'émission dite 'intégrée'. Une telle source d'émission peut être intégrée au composant 100 au cours de la fabrication du substrat émissif. La source d'émission peut notamment comprendre une source optique configurée pour émettre la composante optique d'un signal S₁ₙ associé à la zone d'émission 102-n. La source optique de la source d'émission intégrée peut être, par exemple et sans limitation, une micro LED (encore noté 'mLED' ou 'µLED'), une mini LED, une OLED, ou toute autre source d'émission de lumière ou d'émission laser. La source optique de la source d'émission intégrée peut en outre être une source optique VCSEL (acronyme pour l'expression anglo-saxonne *' Vertical-Cavity Surface-Emitting Lasers'* signifiant 'lasers à émission de surface à cavité verticale'), configurée pour émettre un signal optique de longueur d'onde À égale à 850 nm typiquement.

Dans des modes de réalisation, une zone d'émission 102-n intégrée du composant d'émission 102 peut être configurée pour émettre la composante électrique d'un signal S₁ₙ. Par exemple, une zone d'émission 102-n intégrée peut comprendre un élément source électrique, tel qu'un plot conducteur électrique, avoisinant la source optique intégrée (c'est-à-dire positionné à proximité). La composante électrique d'un signal S₁ₙ peut alors être générée de manière à transiter de l'élément source électrique au composant de réception 202 (via un micro-tube). En outre, une partie au moins de la composante électrique d'un signal S₁ₙ peut être utilisée comme source d'alimentation électrique localisée pour alimenter la source optique intégrée. Par exemple et sans limitations, sur une puce CMOS ou sur un interposer photonique, des matrices de micro LED ou des matrices de sources optiques VCSEL peuvent être pilotées par hybridation, c'est-à-dire par des signaux hybrides optiques et électriques.

L'homme du métier comprendra aisément, que l'expression « composante électrique d'un signal électro-optique » fait référence à une tension de polarisation adaptée pour alimenter des sources optiques ou pour transiter vers un composant de réception 202. En outre, une telle composante électrique peut être adaptée pour transporter une information électrique du composant d'émission 102 vers le composant de réception 202.

Dans d'autres modes de réalisation, le composant émetteur 100 peut comprendre une ou plusieurs sources optiques d'émission 110 dites 'reportées' (non représentées sur les figures). Dans de tels modes de réalisation, le composant émetteur 100 peut être équipé d'un réseau 112 de guides d'ondes optique (non représentées sur les figures) reliant la ou les sources optiques d'émission 110 à la zone d'émission 102 du composant émetteur 100, si une unique zone d'émission est utilisée, ou à au moins une partie des zones d'émission 102-n. du composant émetteur 100, si plusieurs zones d'émission sont utilisées. Une source optique d'émission 110 reportée (dans et/ou sur le substrat émissif par exemple) est configurée pour émettre la composante optique du ou les signaux S₁ₙ se propageant dans le réseau de guides d'ondes optique 112 jusqu'aux zones d'émission. Le réseau de guides d'ondes optique 112 peut en outre être un réseau planaire s'étendant sensiblement dans le plan (X,Y).

Avantageusement, le composant émetteur 100 peut comprendre une ou plusieurs sources électriques d'émission 114 (non représentées sur les figures) et être équipé d'un réseau 116 de connexions électriques (non représentés sur les figures) reliant électriquement la ou les sources électriques d'émission 114 à la zone d'émission 102 ou aux zones d'émission 102-n de signaux électro-optiques S₁ₙ.

Par ailleurs, au moins une partie de la composante électrique d'un signal électro-optique S₁ₙ à émettre par une zone d'émission 102-n peut correspondre, par exemple et sans limitation, à un signal d'alimentation électrique (i.e. courant électrique) adapté pour alimenter et/ou piloter une source optique intégrée de la zone d'émission 102-n.

Une zone d'émission 102-n peut être caractérisée par une géométrie de forme spécifique définie dans le plan (X,Y). Une zone d'émission 102-n peut également être caractérisée par une grandeur notée g₁ₙ relative à la taille de zone sur la face d'émission 104. La géométrie de forme (également appelée ici 'géométrie d'émission') d'une zone, ainsi que sa grandeur g₁ₙ associée, peuvent dépendre de la nature de la zone d'émission 102-n utilisée (i.e. du choix technologique et/ou de l'implémentation intégrée ou reportée utilisée pour les sources d'émission). Par exemple, la géométrie des sources d'émission 102-n (encore appelée 'géométrie d'émission'), sur la face 104, peut être circulaire, comme représenté sur le schéma 2[b] de la figure 2. Dans le cas d'une géométrie d'émission circulaire, la grandeur g₁ₙ peut correspondre au diamètre de la forme circulaire représentant la source d'émission. L'homme du métier comprendra aisément que l'invention n'est pas limitée à des géométries d'émission circulaires et peut comprendre d'autres formes géométriques telles que par exemple et sans limitation une géométrie d'émission carrée, rectangulaire, triangulaire, elliptique, trapézoïdale, hexagonale, polygonale, etc. La ou les grandeurs g₁ₙ associées aux zones d'émission du composant émetteur 100 peuvent être par exemple de l'ordre de quelques micromètres à quelques centaines de micromètres.

Avantageusement, le composant émetteur 100 peut comprendre un matériau 118, dit 'matériau de support d'émission' compatible avec les procédés d'intégration des sources d'émission de signal (de type intégré ou reporté) et/ou avec les procédés associés à de la fabrication microélectronique. Par exemple et sans limitation, le matériau de support d'émission 118 peut être n'importe quel matériau semi-conducteur tel que, par exemple un Wafer ou une partie d'un Wafer, le Wafer pouvant être en Silicium, Germanium, Arséniure de gallium (AsGa), Phosphure d'indium (InP), Silicium cristallin ou autres. Un matériau de support d'émission 118 peut en outre être formé à partir de n'importe quel matériau non semi-conducteur tel que par exemple et sans limitations du verre, du pyrex, des céramiques. Un tel matériau non semi-conducteur peut être avantageusement utilisé dans les modes de réalisation où les sources d'émission 110 sont reportées.

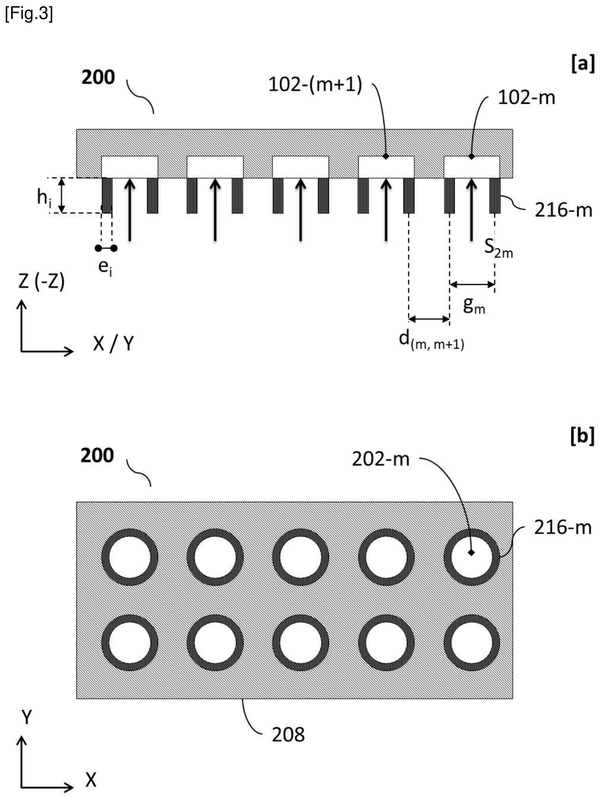

La figure 3 représente deux schémas 3[a] et 3[b], respectivement dans le plan (X,Z) et dans le plan (X,Y), du composant récepteur 200, selon des modes de réalisation de l'invention. Dans les modes de réalisation de la figure 3, le composant récepteur 200 comprend une pluralité de M zones de réception 102-m.

Chaque zone de réception 202-m du composant récepteur 200 est associée (ou reliée) à au moins une zone d'émission 102-n spécifique du composant émetteur 100.

Les zones de réception 202-m du composant récepteur 200 sont adaptées pour recevoir chacune un signal S₂ₘ provenant d'une direction sensiblement parallèle à l'axe normal Z (perpendiculaire au plan (X,Y).

La composante optique d'un signal S₂ₘ (optique ou électro-optique) reçu peut être associée à une bande fréquentielle optique en réception notée *λ*₂ₘ. Dans le dispositif de transmission 10, les composantes optiques des signaux S₂ₘ peuvent être associées à une bande fréquentielle unique, ou alternativement à plusieurs bandes fréquentielles distinctes.

Une zone de réception 202-m peut être distante d'une autre zone de réception 202-(m+1) d'une distance de séparation d_{(m, m+1)}. Une telle distance de séparation d_{(m, m+1)} (correspondant à un 'espacement') peut être définie selon la répartition des zones, à partir d'une distance minimale de séparation de zones de réception. Dans des modes de réalisation, la distance de séparation peut être de l'ordre de quelques micromètres à quelques centaines de micromètres. En particulier, la distance d_{(m, m+1)} peut être égale à une distance d_{(n, n+1)} associée, correspondant à une zone d'émission 102-n.

Les zones de réception 202-m peuvent par exemple être agencées selon une configuration matricielle régulière sur la face de réception 204 du composant récepteur 200, comme représenté dans l'exemple des schémas 2[a] et 2[b] de la figure 2. Une telle configuration matricielle régulière de répartition de zones peut avoir toute structure géométrique adaptée.

Alternativement, les zones de réception 202-m peuvent par exemple être agencées de manière non régulière (c'est-à-dire selon des espacements de zones variables). Par exemple et sans limitation, une répartition non régulière de la pluralité des zones de réception peut correspondre à un composant de réception 202 comprenant au moins un premier ensemble de zones de réception, définies selon un premier espacement de zones, et un deuxième ensemble de zones de réception, définies selon un deuxième espacement de zones.

Dans certains modes de réalisation, la zone de réception 202-m (ou 202) peut comprendre un composant photo-détecteur configuré pour détecter la composante optique d'un signal S₂ₘ optique et/ou électro-optique à recevoir. Par exemple et sans limitation, un tel composant peut être une photodiode ou tout autre capteur photonique, dit 'intégré' au cours de la fabrication du substrat récepteur.

Avantageusement, la composante électrique d'un signal électro-optique S₂ₘ reçu par une zone de réception 202-m peut correspondre à des informations électriques à transmettre au composant récepteur 200. Alternativement, une telle composante peut correspondre à un signal d'alimentation électrique (i.e. courant électrique) adapté pour alimenter et/ou piloter le composant photo-détecteur de la zone 202-m.

Dans des exemples de réalisation, le composant récepteur 200 peut comprendre une ou plusieurs unités d'acquisition 210 configurées pour acquérir la composante optique du ou des signaux S₂ reçus. Le composant récepteur 200 peut en outre être équipé d'un réseau 212 de guides d'ondes optiques (non représentées sur les figures) reliant une zone de réception 202-m ou au moins une partie des zones de réception 202-m aux unités d'acquisition 210 (non représentées sur les figures), dites 'reportées', du composant récepteur 200. Le réseau de guides d'ondes de réception 212 peut être un réseau planaire s'étendant sensiblement dans le plan (X,Y).

Dans des modes de réalisation, le composant émetteur 100 et/ou le composant récepteur 200 équipés de réseaux de guides d'ondes optique peuvent être des circuits discrets, des puces ou circuits intégrés photonique et/ou électrique, ou encore des circuits interposeurs passifs ou actifs.

Dans certains exemples de réalisation, la composante électrique d'un signal électro-optique peut être utilisée pour piloter une modulation de la longueur d'onde, en émission, en propagation et/ou en réception de la composante optique du signal.

Une zone de réception 202-m peut être caractérisée par une géométrie spécifique définie dans le plan (X,Y) et par une grandeur notée g₂ₘ relative à la taille de zone de réception sur la face de réception 204. Une telle géométrie, dite 'géométrie de réception', et la grandeur g₂ₘ associée peuvent notamment dépendre de la nature de la zone de réception utilisée (c'est-à-dire du choix technologique et/ou de l'implémentation intégrée ou reportée de la zone de réception). Par exemple et sans limitation, la géométrie d'une zone de réception peut être circulaire dans le plan (X,Y), comme représenté sur le schéma 3[b] de la figure 3, la grandeur g₂ₘ correspondant alors au diamètre de la forme circulaire. L'homme du métier comprendra aisément que la géométrie des zones de réception 102-m n'est pas limitée à une forme circulaire et peut comprendre toute autre forme géométrique adaptée telle que par exemple et sans limitation, une forme carrée, rectangulaire, triangulaire, elliptique, trapézoïdale, hexagonale, polygonale, etc. Dans des modes de réalisation, la taille de la zone de réception g₂ₘ peut être de l'ordre de quelques micromètres à quelques centaines de micromètres.

Avantageusement, le composant récepteur 200 peut comprendre un matériau 214, dit 'matériau de support de réception', compatible avec les procédés d'intégration des composants photo-détecteurs et/ou des unités d'acquisition de signal (de type intégré ou reporté) et/ou avec les procédés associés à de la fabrication microélectronique, par exemple à l'aide d'outils d'hybridation disponibles dans les technologies du packaging micro-électronique. En particulier, le matériau de support de réception 214 peut être tout matériau semi-conducteur adapté tel que par exemple, un Wafer ou une partie d'un Wafer, le Wafer pouvant être en Silicium, Germanium, Arséniure de gallium (AsGa), Phosphure d'indium (InP), Silicium cristallin ou autres. Un matériau de support de réception 214 peut en outre être formé à partir de n'importe quel matériau non semi-conducteur tel que, par exemple du verre, du pyrex, des céramiques. Un tel matériau non semi-conducteur peut être avantageusement utilisé dans les modes de réalisation où les unités d'acquisition sont reportées.

Le ou les signaux à transmettre à travers le dispositif de transmission 10 peuvent être émis depuis la face d'émission 104 du composant émetteur 100 (signaux S₁ₙ), et reçu par la face de réception 204 du composant récepteur 200 (signaux S₂ₘ), le ou les signaux ayant été propagés dans le composant 300 d'interconnexion entre les deux faces 104 et 204 du dispositif 10.

Le composant d'interconnexion 300 (encore appelé 'interconnecteur optique', 'interconnecteur photonique', ou encore 'interconnecteur électro-optique") peut comprendre un ou plusieurs micro-tubes 310 de propagation de signal. Dans des modes de réalisation, le composant d'interconnexion 300 peut comprendre une pluralité P de micro-tubes 310-p (encore appelé 'plots d'interconnexion'), « p » étant l'indice correspondant au p^{ième} micro-tube du composant d'interconnexion 300. L'indice « p » est donc un entier compris entre 1 et P, et la valeur de P étant un entier supérieur ou égal à 1.

Avantageusement, un micro-tube 310-p peut être configuré pour transmettre au moins un signal issu d'une zone d'émission 102-n du composant émetteur 100 vers le composant récepteur 200 en au moins un signal résultant, réceptionné par une zone de réception 202-m du composant récepteur 200.

En particulier, un micro-tube 310-p de propagation de signal peut être configuré pour transmettre un signal S₁ₙ issu de la zone d'émission 102-n du composant émetteur 100, au composant récepteur 200 en un signal S₂ₘ résultant, réceptionné par la zone de réception 202-m. Les micro-tubes 310-p peuvent correspondre à des canaux de communication transportant les informations optiques entre le composant émetteur 100 et le composant récepteur 200.

Dans la suite de la description, il sera fait principalement en référence à un nombre M de zones de réception 202-m égal au nombre N de zones d'émission 102-n, pour faciliter la compréhension de l'invention et à titre de simplification. Dans ces exemples de réalisation, à titre de simplification, l'indice « m » associé à une zone de réception 202-m sera alors assimilé à l'indice « n » associé à une zone d'émission 102-n. Cependant, l'homme du métier comprendra aisément que la valeur de M associée au nombre de zones de réception 202-n du composant récepteur 200 peut être différente de la valeur N définissant le nombre de zone d'émission 102-n au composant émetteur 100.

Par ailleurs, les micro-tubes 310-p pourront être désignés par la référence 310, dans la suite de la description ou les figures, à titre de simplification également.

Un micro-tube 310 de propagation de signal peut être caractérisé comme un guide d'onde, optique et/ou électro-optique, ayant deux extrémités transversales et comprenant un milieu interne longitudinal 312 et une paroi 314. Le guide d'onde formant le micro-tube est adapté pour propager la composante optique (i.e. portant des informations optiques) d'un signal, à travers le milieu 312, appelé également 'milieu de propagation' ou 'milieu de transmission'. La paroi 314 d'un micro-tube est adaptée pour séparer le milieu de propagation 312 du micro-tube et le milieu ambiant 40 dans lequel est plongé le dispositif 10.

Le milieu ambiant 40 du dispositif 10 peut également être un milieu sous vide, ou un milieu gazeux tel que l'air ou un gaz neutre comme l'azote ou l'argon. Dans ce cas, le dispositif 10 peut être intégré dans une enceinte conçue pour maitriser l'impact du milieu sur la stabilité optique et/ou mécanique des rayons communicants, c'est-à-dire des plots d'interconnexions entre la matrice émissive et la matrice réceptrice, en maitrisant par exemple dans cette enceinte les paramètres de pression et de température. Dans des modes de réalisation, le milieu ambiant 40 du dispositif 10 peut en outre être un milieu solide, ou un milieu hybride tel qu'un matériau dit 'matériau de sous enrobage' (ou *'underfill' en langue* anglo-saxonne). Un tel matériau peut être par exemple de la colle époxy.

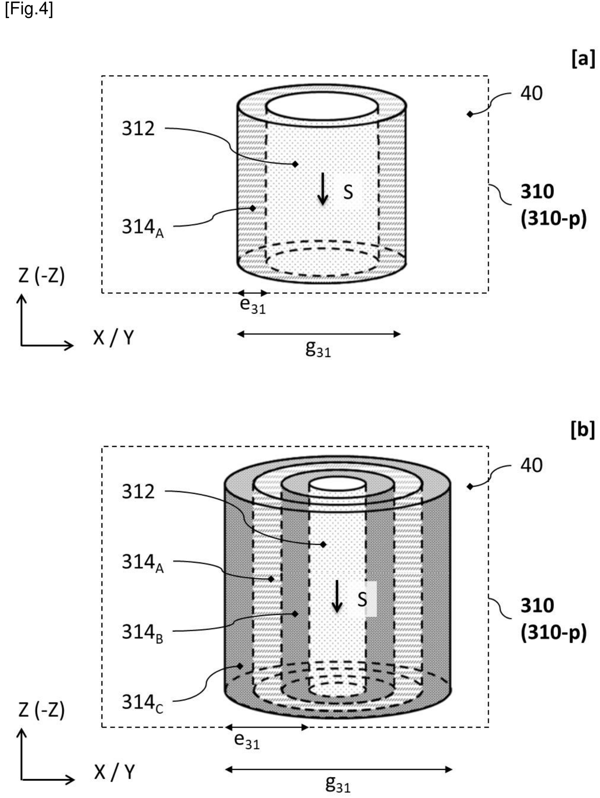

Les schémas 4[a] et 4[b] de la figure 4 illustrent des exemples de micro-tube 310, représenté schématiquement et distinctement dans le milieu ambiant 40, selon une vue en perspective. Un tel micro-tube 310 formant un guide d'onde peut notamment s'étendre selon un axe sensiblement parallèle à l'axe Z du repère (X,Y,Z) associé au dispositif de transmission 10.

Dans des modes de réalisation, le milieu de propagation 312 d'un micro-tube 310 peut correspondre à un corps liquide, à du vide, à un milieu gazeux tel que l'air ou un gaz neutre comme l'azote ou l'argon, ou à un matériau solide ou hybride (ou matériau de remplissage, matériau de scellement) tel que du poly silicium, un oxyde ou encore un nitrure. La composition du milieu de propagation 312 peut être déterminée à partir d'au moins certaines caractéristiques du signal à transmettre.

En particulier, la composition du milieu de propagation 312 peut être choisie en fonction de la différence d'indice optique entre le milieu de propagation 312 et la paroi 314, de manière à optimiser la propagation de la composante optique (portant des informations optiques) du signal à transmettre, à travers le guide d'onde formé par le micro-tube 310, et notamment via le milieu de transmission.

Dans des modes de réalisation, la composition du milieu de propagation 312 peut être choisie en fonction de la composition du milieu ambiant 40 du dispositif 10. En particulier, la composition du milieu de propagation 312 peut être identique à la composition du milieu ambiant 40.

Dans des modes de réalisation, le milieu de propagation 312 peut être un milieu liquide, ce qui permet au dispositif 10 de former une microlentille pour des applications de scanners à immersion. Par exemple et sans limitation, le milieu de propagation 312 peut être de l'eau distillée, de l'eau déionisée et/ou n'importe quel liquide adapté à une fonction de lentille interne de manière à ce que la propagation du signal optique dans ce milieu de propagation 312 soit adaptée au besoin prédéfini par un concepteur du dispositif de transmission 10.

La composition du milieu de propagation 312 peut en outre être définie à partir de la bande fréquentielle optique d'émission *λ*₁ₙ de la composante optique d'un signal S₁ₙ émis par la zone d'émission 102-n. Par exemple et sans limitation, la composition du milieu de propagation 312 peut être choisie de sorte que le milieu de propagation 312 soit transparent (i.e. optiquement transparent) à la composante optique du signal S₁ₙ à transmettre. Dans ce cas, la bande fréquentielle optique d'émission *λ*₁ₙ de la composante optique du signal S₁ₙ pénétrant dans le milieu 312, peut être sensiblement égale (ou équivalente) à la bande fréquentielle optique en réception *λ*₂ₙ de la composante optique du signal S₂ₙ propagé à travers le milieu de propagation 312. Cette concordance de bande fréquentielle entre le signal émis et le signal résultant en sortie du micro-tube 310 permet de garantir une faible atténuation, c'est-à-dire une faible perte, des informations optiques par transmission dans le composant d'interconnexion 300.

Alternativement, la composition du milieu de propagation 312 peut être choisie pour que ce milieu ait des fonctions de filtrage et/ou de décalage optique telles que les bandes fréquentielles optique d'émission *λ*₁ₙ et en réception λ₂ₙ soient différentes (c'est-à-dire distinctes entre elles). Un exemple de fonction de filtrage peut être une fonction de filtrage appliquée en fonction de l'indice optique de la composition du milieu de propagation 312 choisie.

Dans une variante de l'invention, la composition du milieu de propagation 312 peut avoir des propriétés optiques actives ou variables en fonction de modifications de l'état physique du dispositif 10 ou du composant d'interconnexion 300. La composition du milieu de propagation 312 peut être choisie notamment pour que son indice optique soit modifiable en fonction de changements de conditions thermiques et/ou ambiantes. Par exemple et sans limitation, ces modifications peuvent permettre d'induire une accordabilité active aux bandes fréquentielles optique d'émission *λ*₁ₙ et/ou en réception *λ*₂ₙ, en réponse à une commande de modification de la température du milieu ambiant 40.

Par ailleurs, la composition du milieu de propagation 312 peut être un milieu de transmission à rotation de polarisation, ou alternativement à maintien de polarisation de sorte que la polarisation de la composante optique du signal S₁ₙ émis soit sensiblement égale (ou équivalente) à la polarisation de la composante optique du signal S₂ₙ reçu. Par exemple, une telle rotation de polarisation peut être générée (ou obtenue) en fonction de l'indice optique de la composition du milieu de propagation 312 choisie.

Dans des modes de réalisation, la paroi 314 d'un micro-tube 310 peut comprendre une unique épaisseur (ou mur), notée 314_{A}, comme illustré sur le schéma 4[a] de la figure 4.

Avantageusement, la paroi 314 (ou 314_{A}) d'un micro-tube 310 peut comprendre une unique épaisseur métallique ou diélectrique. Par exemple et sans limitation, une telle épaisseur de paroi sur la figure 4[a], peut être composée de tungstène, ayant une conductivité électrique faible, ou d'un matériau d'oxyde.

Selon certains modes de réalisation, la paroi 314 d'un micro-tube 310 peut comprendre plusieurs épaisseurs (ou murs) distinctes. En particulier, une telle paroi 314 peut comprendre au moins une épaisseur diélectrique et au moins une épaisseur métallique. Par exemple et sans limitation, une paroi 314 peut comprendre une partie diélectrique centrale 314_{A}, une partie métallique interne 314_{B} et/ou une partie métallique externe 314c concentriques, ayant chacune une forme de cylindre creux (i.e. dont les bases sont des couronnes), de même axe que le micro-tube 310, comme représenté sur le schéma 4[b] de la figure 4. Chaque partie 314_{A}, 314_{B} et 314c a une épaisseur donnée (égale à la différence entre le rayon externe et le rayon interne des couronnes formant la base de chaque partie). Une partie métallique 314_{B} ou 314c de la paroi 314 peut être composée d'aluminium ou d'or par exemple. Une partie métallique 314_{B} ou 314c de la paroi 314 peut également comprendre une couche dite 'couche d'accrochage' (non représentée sur les figures) adossée à la partie diélectrique 314_{A} de la paroi 314 du guide d'onde, qui peut être composée de titane ou de titane nitruré par exemple.

La métallisation interne et/ou externe de la paroi 314 d'un micro-tube 310 peut permettre la propagation (ou transmission) de la composante électrique des signaux, portant des informations électriques, le long de la paroi métallisée du guide d'onde.

Ainsi, la composante électrique d'un signal S₁ₙ issu d'une zone d'émission 102-n peut être transportée du composant d'émission 102 vers le composant de réception 202 à travers une propagation dans le composant d'interconnexion 300, et en particulier un micro-tube 310. Un micro-tube 310 peut donc avoir une double fonction de transport d'informations optique et électrique. La composante électrique d'un signal S₁ₙ peut en outre être adaptée pour commander certaines fonctionnalités du micro-tube 310 sur lequel elle se propage. Par exemple et sans limitation, une accordabilité active des bandes fréquentielles optiques en émission *λ*₁ₙ et/ou en réception *λ*₂ₙ par une modification de l'indice optique de la composition du milieu de propagation 312-n d'un micro-tube 310-n peut être mise en œuvre, en réponse à une commande électrique issue de la composante électrique d'un signal S₁ₙ qui traverse le micro-tube.

La paroi 314 d'un micro-tube 310 peut être caractérisée par une épaisseur globale de paroi e₃₁ (différence entre le rayon intérieur et le rayon extérieur du micro-tube 310 si le micro-tube à une section annulaire par exemple) qui peut avoir une valeur de l'ordre de quelques micromètres à quelques dizaines de micromètres. Une telle épaisseur globale de paroi 314 peut dépendre du pas du réseau des micro-tubes 310-p dans le dispositif de transmission 10. Avantageusement, les parties métalliques 314_{B} et/ou 314c d'une paroi 314 peuvent avoir une valeur de l'ordre de quelques dizaines de nanomètres à quelques centaines de nanomètres.

Dans des modes de réalisation, un micro-tube 310 (et plus particulièrement sa paroi 314) peut être caractérisé par une géométrie donnée (dite 'géométrie transversale') dans le plan (X,Y) et par une grandeur de section g₃₁ relative à la section du micro-tube 310 dans le plan (X,Y). La forme de la géométrie transversale du micro-tube 310 et sa grandeur g₃₁ peuvent être notamment déterminées en fonction de performances de la transmission d'un signal optique et/ou électro-optique à travers le guide d'onde formé par le micro-tube. Avantageusement, la géométrie transversale de guide peut être annulaire dans le plan (X,Y), comme représenté sur les schémas 4[a] et 4[b] de la figure 4. L'homme du métier comprendra aisément qu'un micro-tube 310 n'est pas limité à de telles formes de géométrie transversale et peut avoir d'autres formes de géométrie transversale (i.e. la section du micro-tube 310 peut avoir d'autres formes géométriques) telles que par exemple une forme carrée, rectangulaire, triangulaire, elliptique, trapézoïdale, ou toute autre forme adaptée. Dans le cas d'une géométrie transversale annulaire du micro-tube 310, la grandeur de section g₃₁ d'un micro-tube peut correspondre à son diamètre interne par exemple, comme représenté sur les schémas 4[a] et 4[b] de la figure 4. La grandeur de section g₃₁ peut être de l'ordre de quelques micromètres à quelques dizaines de micromètres. La grandeur de section g₃₁ des micro-tubes du composant d'interconnexion 300 peut être définie en fonction de la densité de répartition des sources optiques du composant émetteur 100.

La suite de la description sera principalement faite en référence à un micro-tube de section annulaire à titre d'exemple non limitatif, afin de faciliter la compréhension de l'invention.

Les matériaux de composition, les formes et les différentes dimensions associés aux micro-tubes 310 peuvent être choisis de manière à obtenir une tenue mécanique optimale du composant 300. Par exemple, l'utilisation de matériau d'oxyde pour générer le milieu de propagation 312 et/ou la paroi 314 d'un micro-tube 310-p peut permettre d'améliorer la liaison mécanique entre le composant émetteur 100 et le composant récepteur 200.

Le composant d'interconnexion 300 peut comprendre une pluralité d'ensembles optiques 50-n, chaque ensemble optique 50-n comprenant au moins une zone d'émission 102, un micro-tube associé 310 et une zone de réception associée 202 reliée à la zone d'émission 102 par le micro-tube 310.

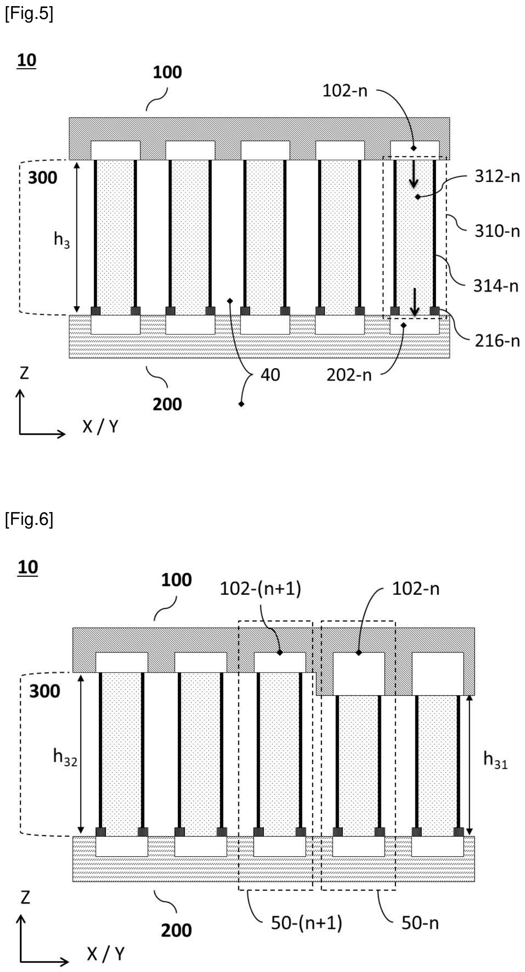

La figure 5, la figure 6 et la figure 7 représentent schématiquement des modes de réalisation d'un composant d'interconnexion 300 dans un dispositif de transmission 10. Le composant d'interconnexion 300 peut comprendre des micro-tubes 310-p (ou groupes de micro-tubes) adjacents et disposés parallèlement entre eux, s'étendant selon un axe sensiblement parallèle à l'axe Z.

Il est à noter qu'une paroi 314 multi-épaisseurs formée d'une partie diélectrique 314_{A} composée de plusieurs couches de diélectriques d'indices optiques variables, ou comprenant au moins une partie métallisée 314_{B} et/ou 314c, peut avantageusement permettre une opacification de la paroi du guide d'onde. Une épaisseur de paroi 314 dite 'opacifiante' permet d'augmenter la différence d'indices optiques résultante entre le milieu de propagation 312 et la paroi 314 du guide d'onde. Une telle augmentation induit une amélioration de la propagation de la composante optique des signaux dans le milieu de propagation 312, c'est-à-dire le long d'un micro-tube 310 en diminuant ou en évitant les fuites de signaux optiques. Une paroi opacifiée pour une pluralité de micro-tubes adjacents 310-p permet ainsi de diminuer les communications parasites entre ces différents micro-tubes. L'effet de 'diaphonie' qui peut apparaître dans des dispositifs de connexions verticales classiques est donc significativement réduit par une telle opacification.

Par ailleurs, il est à noter qu'une paroi 314 mono-épaisseur formée d'une unique partie diélectrique 314_{A}, générée à partir d'une épaisseur métallique, peut avantageusement permettre une opacification de la paroi du guide d'onde et donc éviter les phénomènes de fuites optiques (i.e. effet de 'diaphonie') entre les différentes voies optiques formées par l'ensemble des micro-tubes juxtaposés.

Dans les exemples des figures 5, 6 et 7, il est considéré que le nombre M de zones de réception 202-m est égal au nombre N de zones d'émission 102-n, l'indice « m » d'une zone de réception 202-m étant alors substitué à l'indice « n » d'une zone d'émission 102-n.

Dans des modes de réalisation, la valeur de P peut être égale à la valeur N correspondant au nombre de zones d'émission 102-n du composant émetteur 100 (elle-même égale à la valeur M du nombre de zones de réception du composant récepteur 200), comme représenté par les figures 5, 6 et 7. Dans ce cas, l'indice « p » d'un micro-tube 310-p est assimilé à l'indice « n » des zones d'émission 102-n associées (et donc à l'indice « m » des zones de réception 202-m), à titre de simplification.

En particulier, la figure 5 représente schématiquement un composant d'interconnexion 300 comprenant une pluralité N (égale à P) de micro-tubes 310-n, selon des modes de réalisation de l'invention, chaque micro-tube 310-n pouvant être configuré pour transmettre directement le n^{ième} signal S₁ₙ issu d'une zone d'émission 102-n du composant émetteur 100 au composant récepteur 200, un n^{ième} signal S₂ₙ résultant étant alors réceptionné par la zone de réception 202-n. Chaque zone de réception 202-n peut ainsi être reliée à une zone d'émission 102-n correspondante, via un micro-tube 310-n associé. La longueur du composant d'interconnexion 300 peut alors correspondre sensiblement à la hauteur h₃ des micro-tubes 310-n, et peut être de l'ordre de quelques micromètres à quelques dizaines de micromètres.

Un micro-tube 310-n du composant d'interconnexion 300 peut ainsi s'étendre longitudinalement entre le composant émetteur 100 et le composant récepteur 200 pour coupler optiquement la zone d'émission 102-n, associée au micro-tube, à la zone de réception 202-n correspondante.

L'agencement des micro-tubes 310-n peut avoir une configuration définie par rapport à l'agencement des zones d'émission 102-n et des zones de réception 202-n. Par exemple, l'agencement des micro-tubes 310-n peut avoir une configuration matricielle régulière en réseau de micro-tubes. Alternativement, l'agencement des micro-tubes 310-n peut être défini selon une répartition non régulière des micro-tubes. Par exemple et sans limitation, une répartition non régulière de la pluralité des micro-tubes peut correspondre à un composant d'interconnexion 300 comprenant au moins un premier ensemble de micro-tubes, définis selon un premier espacement de micro-tubes, et un deuxième ensemble de micro-tubes, définis selon un deuxième espacement de micro-tubes.

Avantageusement, l'agencement des micro-tubes 310-n peut être déterminé en fonction des contraintes d'agencement des zones d'émission 102-n et/ des zones de réception 202-n.

Les géométries d'émission, de réception, et transversale de chaque ensemble optique 50-n du dispositif de transmission 10 peuvent être avantageusement centrées sur un même axe, parallèle à l'axe Z.

Dans les modes de réalisation où la pluralité des zones d'émission comprend différents ensembles des sources hybrides, le composant d'émission 102 peut comprendre une face d'émission 104, comprenant différentes sections de niveau distinctes, comme illustré sur la figure 6. En particulier, le composant d'émission 102 peut comprendre :
- un premier ensemble, correspondant par exemple et sans limitation à des sources issues d'une puce de type CMOS comprenant la zone d'émission de référence 102-n représentée sur la figure 6, et
- un deuxième ensemble d'autres éléments émissifs comprenant la zone d'émission de référence 102-(n+1) représentée sur la figure 6.

Les sources du premier ensemble peuvent avoir chacune une première taille et les éléments émissifs de deuxième ensemble peuvent avoir chacun une deuxième taille, tel que l'épaisseur résultant du composant d'émission 102 (entre la face 104 et la face 106) peut être sensiblement variable d'un ensemble à l'autre (i.e. d'une zone d'émission à l'autre). Une variable d'épaisseur peut être égale à au moins deux valeurs distinctes définies respectivement par la première et la deuxième taille des zones d'émission.

L'homme du métier comprendra aisément que le composant de réception 202 peut similairement comprendre différents ensembles de zones de réception telle que l'épaisseur du composant de réception 202 (entre la face de réception 204 et la face 206) peut être sensiblement variable d'un ensemble à l'autre (i.e. d'une zone de réception à l'autre), selon un mode de réalisation non représenté sur les figures.

Avantageusement, les micro-tubes du composant d'interconnexion 300 peuvent alors avoir différentes hauteurs entre les différentes zones d'émission et de réception du dispositif de transmission 10. En particulier, le composant d'interconnexion 300 peut comprendre un premier ensemble de micro-tubes et un deuxième ensemble de micro-tubes, tels que la hauteur des micro-tubes (entre la face d'émission 104 et la face de réception 204) peut être sensiblement variable d'un ensemble à l'autre. Par exemple, la hauteur des micro-tubes du premier ensemble de micro-tubes peut être égale à une première valeur et la hauteur des micro-tubes du deuxième ensemble de micro-tubes peut être égale à une deuxième valeur distincte de la première valeur. Par exemple et sans limitation, comme illustré sur la figure 6, le dispositif 10 peut comprendre au moins un premier ensemble optique 50-n et un deuxième ensemble optique 50-(n+1), et le micro-tube 310-n associé au premier ensemble optique 50-n peut être caractérisée par une hauteur h₃₁ de valeur inférieur à la hauteur h₃₂ du micro-tube 310-(n+1) associé au deuxième ensemble optique 50-(n+1).

La variabilité de hauteurs des micro-tubes du composant d'interconnexion 300 permet de compenser, lors de la fabrication de ces micro-tubes, les variabilités d'épaisseurs ou de niveaux des composants hybrides d'émission 100 et/ou de réception 200. Une telle variabilité de hauteurs des micro-tubes permet également de compenser de simples défauts de planéité des composants d'émission 100 et/ou de réception 200 composés de même éléments, ou bien hybrides.

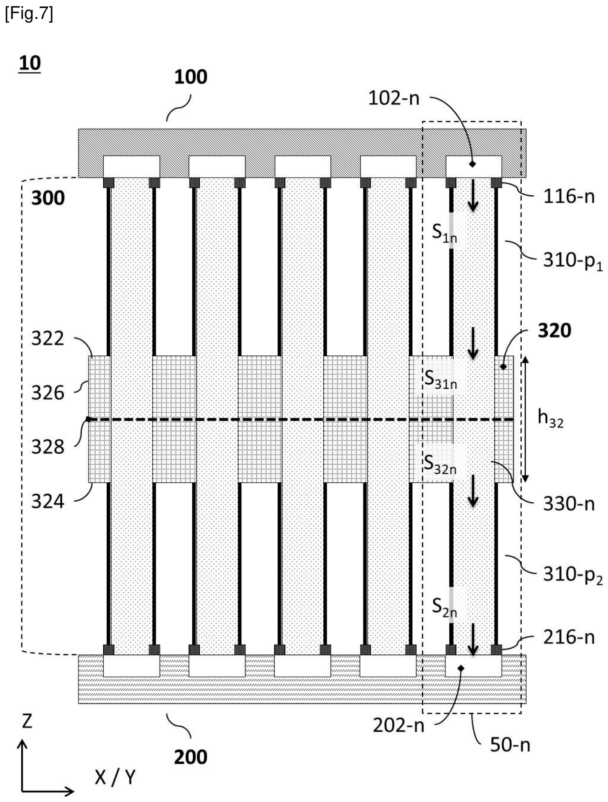

Dans des modes de réalisation, un ensemble optique 50-n peut comprendre un élément de raccord 116-n associée à la zone d'émission 102-n de l'ensemble optique 50-n et configuré pour raccorder le composant émetteur 100 au composant d'interconnexion 300. Un élément de raccord 'en émission' 116-n peut être agencé sur la face d'émission 104 au niveau de la zone d'émission 102-n, comme illustré sur la figure 7.

Dans des modes de réalisation, un ensemble optique 50-n peut comprendre un élément de raccord 216-n, associé à la zone de réception 202-n de l'ensemble optique 50-n et configuré pour raccorder le composant récepteur 200 au composant d'interconnexion 300. Un élément de raccord 'en réception' 216-n peut alors être positionné sur la face de réception 204 au niveau de la zone de réception 202-n, comme illustré sur les figures 5, 6 et 7.

Avantageusement, un élément de raccord en émission et/ou en réception 116-n ou 216-n a une section pouvant avoir toute forme géométrique adaptée, dans le plan (X,Y), et être caractérisé par une grandeur gₙ relative à un paramètre de dimension de la forme géométrique de la section de l'élément de raccord dans le plan (X, Y). En particulier, la forme géométrique et la grandeur gₙ d'un élément de raccord 116-n ou 216-n peuvent être choisis en fonction de la forme de la section transversale du micro-tube 310-n associé et des dimensions de cette section. La forme géométrique de la section d'un élément de raccord 116-n et/ou 216-n, dans le plan (X, Y), peut être la même que la forme géométrique (i.e. géométrie transversale) de la section du micro-tube associé 310-n, et être centrée sur le même axe que le micro-tube 310-n. Un élément de raccord 116-n et/ou 216-n peut être agencé entre la zone d'émission associée 102-n et/ou respectivement la zone de réception associée 202-n, d'une part, et le bord supérieur et/ou respectivement le bord inférieur de la paroi 314 du micro-tube associé 310-n, au niveau de son extrémité supérieure et/ou respectivement inférieure.

Dans le cas où un micro-tube 310-n a une forme cylindrique, un élément de raccord 116-n et/ou 216-n peut avoir une section de forme annulaire (c'est-à-dire en forme d'anneau) dans le plan (X,Y) adaptée à la forme annulaire de la section transversale de la paroi 314 du micro-tube pour pouvoir être maintenu entre la zone d'émission associée 102-n et/ou respectivement la zone de réception associée 202-n, d'une part, et le bord supérieur et/ou le bord inférieur de la paroi 314 respectivement, d'autre part. Dans de tels modes de réalisation, un élément de raccord en émission 116-n et/ou 216-n peut être centré autour du centre de la zone d'émission 102-n et/ou de la zone de réception 202-n respectivement, comme représenté par exemple sur les schémas 2[b] de la figure 2 et 3[b] de la figure 3.

Un élément de raccord 116-n ou 216-n peut avoir une section de toute forme géométrique, de manière adaptée à la forme de la section transversale du micro-tube 310, comme par exemple une forme carrée, rectangulaire, triangulaire, elliptique, trapézoïdale, hexagonale, polygonale, etc. Un élément de raccord 116-n ou 216-n peut avoir une taille de l'ordre de quelques micromètres à quelques centaines de micromètres.

L'agencement des différents ensembles optiques 50-n les uns par rapport aux autres peut avoir toute configuration adaptée. Les différents éléments (ou objets) d'un même ensemble optique 50-n (pouvant comprendre la zone d'émission 102-n, la zone de réception 202-n, le micro-tube 310-n, et le ou les éléments de raccord 116-n et 216-n) peuvent être centrés autour du même axe (axe parallèle à l'axe Z), cet axe pouvant passer par le centre de la zone d'émission 102-n et de la zone de réception 202-n.

Dans l'exemple des figures 5, 6 et 7, le dispositif de transmission 10 comprend plusieurs ensembles optiques 50-n (5 ensembles optiques dans ces exemples), chaque ensemble optique comprenant une zone d'émission 102-n pouvant notamment être raccordée (ou connectée) à un micro-tube 310-n par un élément de raccord en émission 116-n, et une zone de réception 202-n raccordée (ou connectée) au micro-tube 310-n par un élément de raccord en réception 216-n. Un élément de raccord 116-n et/ou 216-n (encore appelé 'plot d'accueil') peut par exemple être composé d'un matériau métallique malléable.

Telle qu'utilisée ici, l'expression 'malléable' (ou ductile) fait référence à la capacité d'un matériau à résister à des contraintes sans se rompre, en particulier des contraintes de compression. Par exemple et sans limitation, un élément de raccord peut être formé au moins en partie d'or, d'indium, d'aluminium, ou autre.

Un élément de raccord 116-n et/ou 216-n permet d'assurer la transmission dans le dispositif de transmission 10 du signal optique et/ou électro-optique, dans chaque ensemble optique 50-n, au niveau de la jonction entre une zone d'émission 102-n et le micro-tube 310-n associé, et/ou entre une zone de réception 202-n et le micro-tube 310-n associé respectivement. Ainsi, les éléments de raccord 116-n et 216-n permettent une « étanchéité » optique, et avantageusement le contact électrique (ou la connexion électrique) entre les éléments de jonction des composants de dispositif 10. Les éléments de raccord 116-n et 216-n sont ainsi des éléments de raccord électriques et d'étanchéité optique. Les éléments de raccord 116-n et 216-n sont également des éléments de raccord mécaniques, l'insertion de chaque micro-tube dans au moins un plot d'accueil permettant d'assurer la tenue mécanique entre les différents composants du dispositif 10.

Dans des modes de réalisation, la valeur de P correspondant au nombre de micro-tubes 310-p peut être différente du nombre N de zones d'émission 102-n du composant émetteur 100 (M étant égal à N). Dans de tels modes de réalisation, chaque ensemble optique 50-n peut comprendre une pluralité de micro-tubes 310-pₖ (l'indice « k » étant un entier compris entre 1 et K, K étant le nombre de micro-tubes 310 par ensemble optique 50-n) de même axe et de même section, agencés entre la zone d'émission 102-n et la zone de réception 202-n de l'ensemble optique 50-n.

Dans des modes de réalisation, un composant d'interconnexion 300 peut comprendre un nombre de micro-tubes égal à un multiple de N, selon des modes de réalisation de l'invention. Le composant d'interconnexion 300 peut comprendre une pluralité de micro-tubes subdivisée (ou entrecoupée) par au moins un substrat intermédiaire 320. En particulier, un substrat intermédiaire 320 du composant 300 peut être adapté pour délimiter deux ensembles de micro-tubes, de part-et d'autre d'un substrat intermédiaire. Le nombre total P de micro-tubes 310 du dispositif de transmission peut par exemple être égal à deux fois N, comme illustré par la figure 7. Dans le cas de la figure 7, chaque ensemble optique 50-n comprend deux micro-tubes 310-p₁ et 310-p₂ (K=2) séparés par un substrat intermédiaire 320 traversant le composant d'interconnexion 300, et chaque ensemble optique comprend le même nombre de micro-tubes 310 (K=2).

Le substrat intermédiaire 320 peut avoir une structure généralement plane, s'étendant dans le plan (X,Y). Le substrat intermédiaire 320 du composant d'interconnexion 300 peut comprendre une première face 322 (également appelée 'face d'entrée'), faisant face à la face 104 du composant émetteur, et une deuxième face 324 (également appelée 'face de sortie') opposée à la première face 322 et faisant face à la face 204 du composant récepteur 200. Les première et deuxième faces 322 et 324 du substrat intermédiaire 320 peuvent être sensiblement parallèles entre elles, définies dans le plan (X,Y), et être reliées par un bord latéral 326 (dans le plan (Y, Z)), comme représenté sur la figure 7. Le substrat intermédiaire 320 peut avoir toute forme géométrique et dimension adaptées.

Avantageusement, un substrat intermédiaire 320 du composant d'interconnexion 300 peut être adapté pour assurer la transmission de signaux (optiques et/ou électro-optiques), entre les micro-tubes 310 d'un même ensemble optique 50-n (dans le cas de la figure 7, entre les deux-micro-tubes 310-p₁ et 310-p₂ de la paire de micro-tubes de chaque ensemble optique 50-n). Les micro-tubes 310 d'un même ensemble optique 50-n (micro-tubes 310-p₁ et 310-p₂ dans le cas de la figure 7) s'étendent selon un même axe, sensiblement parallèle à l'axe Z. Comme représenté sur la figure 7, le premier micro-tube 310-p₁ est connecté d'une part à la zone d'émission 102-n et d'autre part à la face 322 d'entrée du substrat intermédiaire 320 qui est apte à recevoir un signal à propager dans le substrat intermédiaire 320. Le deuxième micro-tube 310-p₂ est connecté d'une part à la face de sortie 324 du substrat intermédiaire, par laquelle sort le signal propagé dans le substrat intermédiaire 320, et d'autre part à la zone de réception 202-n du dispositif photonique 10.

Le substrat intermédiaire 320 peut comprendre un ou plusieurs micro-vias (ou micro-trous) de propagation d'un signal, selon des modes de réalisation de l'invention. En particulier, le substrat intermédiaire 320 peut comprendre une pluralité de N micro-vias 330-n (encore appelé 'micro-vias d'interconnexion'), chaque micro-via 330-n étant associé à un ensemble optique 50-n et étant configuré pour transmettre le n^{ième} signal S₃₁ₙ issu du premier micro-tube 310-p₁ de l'ensemble optique 50-n au deuxième micro-tube 310-p₂ de l'ensemble optique 50-n, sous la forme d'un n^{ième} signal S₃₂ₙ résultant de la traversée du substrat intermédiaire 320.

L'agencement et la configuration des micro-vias 330-n peut être adapté à l'agencement et à la configuration des différents ensembles optiques 50-n.

Chaque micro-via 330-n de propagation de signal dans un substrat intermédiaire 320 peut être caractérisé sous la forme d'un guide d'onde, optique et/ou électro-optique, comprenant un milieu longitudinal 332-n et une paroi s'étendant selon un axe sensiblement parallèle à l'axe Z du repère (X,Y,Z) associé au dispositif de transmission 10. Le guide d'onde caractérisant un micro-via 330-n est adapté pour propager la composante optique (i.e. portant des informations optiques) d'un signal au travers du milieu de propagation 332-n. La paroi d'un micro-via 330-n peut alors être formée par la séparation entre le milieu de propagation 332-n et le substrat intermédiaire 320.

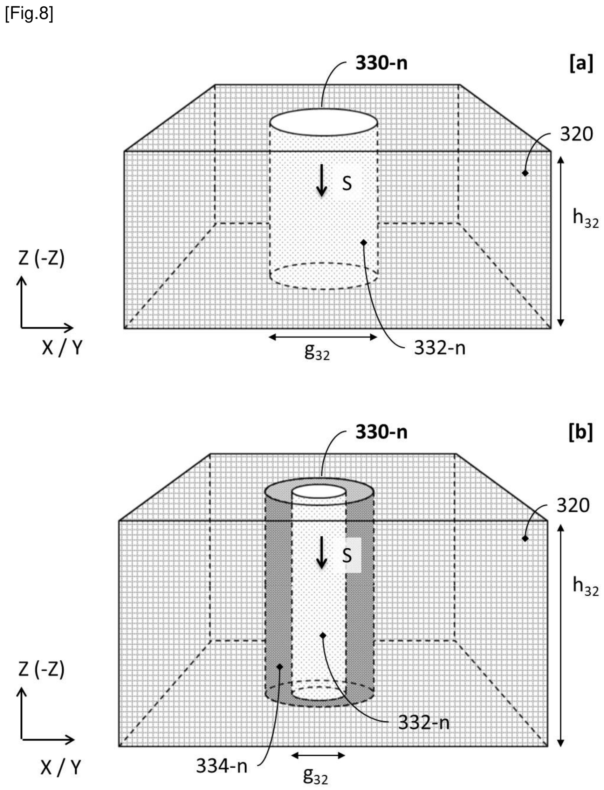

Les schémas 8[a] et 8[b] de la figure 8 illustrent schématiquement un micro-via 330-n, agencé dans un substrat intermédiaire 320, selon une vue en perspective.

Le milieu de propagation 332-n du signal dans un micro-via 330-n peut correspondre à du vide, à un corps liquide, à un milieu gazeux tel que l'air ou un gaz neutre comme l'azote ou l'argon, ou à un matériau (ou matériau de remplissage) solide tel que du poly silicium, un oxyde, un polymère ou encore un nitrure. Avantageusement, le milieu 332-n de propagation du signal dans un micro-via 330-n peut être sensiblement identique au milieu de propagation 312 du ou des micro-tubes 310 du même ensemble optique 50-n.

Dans des modes de réalisation, un micro-via 330-n peut comprendre une surface métallique 334-n, d'épaisseur donnée, sur le pourtour du guide d'onde (i.e. paroi), comme représenté sur le schéma 8[b] de la figure 8. La surface (ou paroi) métallique 334-n du micro-via 330-n peut avoir une forme de cylindre creux. La surface métallique 334-n du micro-via 330-n peut par exemple être composée d'aluminium, de cuivre ou d'or et peut avoir une épaisseur de l'ordre de quelques dizaines de nanomètres à quelques centaines de nanomètres.

Dans des modes de réalisation, le substrat intermédiaire 320 peut être formé à partir d'un ou plusieurs matériaux semi-conducteurs tels que, par exemple et sans limitation, à partir d'au moins une partie d'un Wafer en Silicium, Germanium, Arséniure de gallium (AsGa), Phosphure d'indium (InP), Silicium cristallin, en verre, en Saphir, en matériaux céramiques, ou autre. Le substrat intermédiaire 320 peut être composé de tout type de support plan conforme à des critères de microélectronique, tels que des critères selon les normes SEMI par exemple. La hauteur h₃₂ des micro-vias 320-n (selon l'axe Z) est alors égale à la hauteur du substrat intermédiaire 320 (selon l'axe Z). La hauteur h₃₂ d'un micro-via 320-n peut être par exemple de l'ordre de quelques dizaines de micromètres à quelques millimètres.

Dans des modes de réalisation, le substrat intermédiaire 320 peut être formé de plusieurs sous-substrats intermédiaires, séparés deux à deux par une interface 328 (une interface 328 est ainsi interposée entre deux sous-substrats intermédiaires), comme représenté sur la figure 7. Une interface 328 peut comprendre par exemple une couche de montage composée d'une colle transparente optiquement à la composante optique des signaux à propager le long des micro-vias 320-n. Cette interface 328 peut en outre être formée par collage polymère, par exemple à partir d'une colle de type époxyde, polyimide, acrylique ou silicone. Les colles de type époxyde peuvent être isolantes, conductrices, thermo-conductrices (pour une dissipation favorable de la chaleur) ou électro-conductrices (pour favoriser à la fois une dissipation de la chaleur et une liaison électrique entre deux substrats assemblés). Par ailleurs, le substrat intermédiaire 320 peut être formé par un brasage de type métallique (ou collage métallique), c'est-à-dire via un assemblage de sous-substrats par brasure utilisant des alliages fusibles tels ceux issus de la famille de l'étain ou de l'Indium. Le substrat intermédiaire 320 peut en outre être formé à partir d'un assemblage de sous-substrats utilisant un collage hybride, c'est-à-dire via un collage direct sans couche de collage intermédiaire entre deux surfaces de substrat mixtes comprenant des parties diélectriques (par exemple de l'oxyde ou du SiO₂) et des parties métalliques (par exemple de cuivre), en mettant en regard les parties métalliques des deux surfaces de sorte à réaliser une connexion électrique entre les parties métalliques assemblées. Un collage métallique ou hybride permet une transmission de la composante électrique des signaux à propager le long des micro-vias 320-n (i.e. transit d'information électrique). L'interface de collage est dans ce cas d'épaisseur sensiblement négligeable par rapport à la hauteur h₃₂ des micro-vias 320-n.

La métallisation 334-n de la paroi d'un micro-via 330-n permet la propagation (ou transmission) de la composante électrique (portant des informations électriques) du signal le long de la paroi métallisée du micro-via 330-n, à travers le substrat intermédiaire 320 du composant d'interconnexion 300. De plus, une telle métallisation peut également permettre une augmentation de la différence d'indices de réfraction entre le milieu de transmission 332-n et le matériau du substrat intermédiaire 320 de façon à améliorer la propagation de la composante optique du signal à travers le milieu de transmission.

Un micro-via 330-n peut être caractérisé par une section transversale ayant une forme géométrique donnée dans le plan (X,Y) et par une grandeur notée g₃₂ₙ relative à un paramètre de dimension de la section du micro-via 330-n. Avantageusement, la forme géométrique de la section transversale du micro-via 330-n peut être généralement circulaire dans le plan (X,Y), comme représenté dans les schémas 8[a] et 8[b] de la figure 8. Dans ce cas, la grandeur caractéristique g₃₂ₙ d'un micro-via peut correspondre au diamètre ou au rayon de sa section, et être de l'ordre de quelques micromètres à quelques centaines de micromètres. Dans des modes de réalisation, la grandeur caractéristique g₃₂ₙ d'un micro-via 330-n peut être égale à la grandeur caractéristique g₃₁ du ou des micro-tubes 310 du même ensemble optique 50-n. Alternativement, la grandeur caractéristique g₃₂ₙ peut être différente de la grandeur caractéristique g₃₁ dans un même ensemble optique 50-n. Par exemple et sans limitation, une grandeur caractéristique g₃₂ₙ d'un micro-via 330-n, supérieure à une grandeur caractéristique g₃₁ d'un micro-tube 310-n positionné en amont du micro-via 330-n, permet d'épanouir optiquement le faisceau d'entrée du micro-via 330-n, et notamment d'élargir la taille du faisceau du signal S₃₁ₙ. Une grandeur caractéristique g₃₂ₙ d'un micro-via 330-n, inférieure à une grandeur caractéristique g₃₁ d'un micro-tube 310-n positionné en amont du micro-via 330-n, permet de focaliser optiquement le faisceau d'entrée du micro-via 330-n, et notamment de réduire la taille du faisceau du signal S₃₁ₙ.

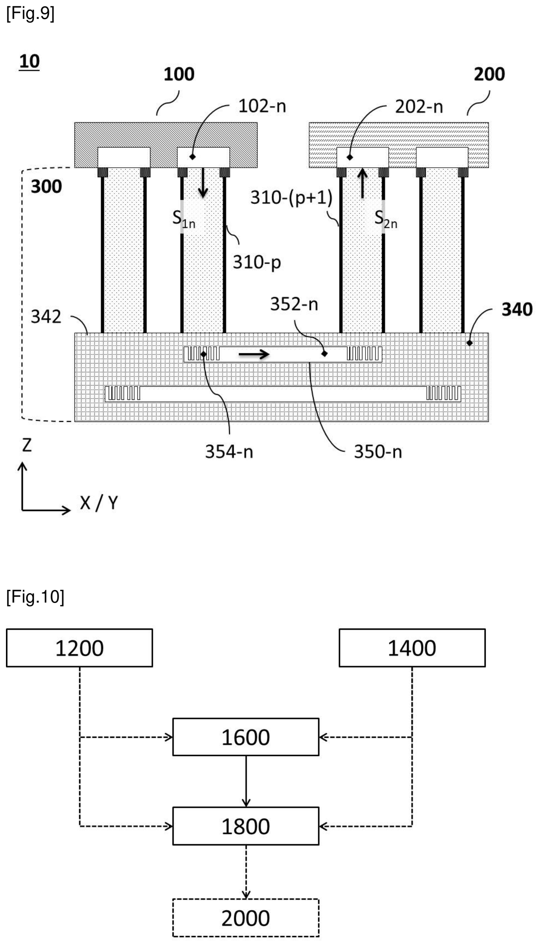

Dans des modes de réalisation, le composant d'interconnexion 300 peut alternativement comprendre une pluralité de micro-tubes subdivisée (ou entrecoupée) par au moins une unité de transfert 340, chaque unité délimitant deux ensembles de micro-tubes de part et d'autre de l'unité de transfert 340, comme illustré sur la figure 9.

Dans de tels modes de réalisation utilisant une unité de transfert 340, chaque ensemble optique 50-n comprend une pluralité de micro-tubes 310-pₖ (« k » étant compris entre 1 et K, K étant le nombre de micro-tubes 310 par ensemble optique 50-n) sensiblement parallèles et de même section mais non colinéaires, agencés entre la zone d'émission 102-n et la zone de réception 202-n de l'ensemble optique 50-n.

Dans l'exemple de la figure 9, chaque ensemble optique 50-n comprend deux micro-tubes 310-p₁ et 310-p₂ (K=2) séparés par une unité de transfert 340 traversant le composant d'interconnexion 300, et chaque ensemble optique comprend le même nombre de micro-tubes 310 (K=2). Ainsi, dans l'exemple de la figure 9, le nombre P de micro-tubes est égal à deux fois N. Les deux micro-tubes 310-p₁ et 310-p₂ d'un même ensemble optique peuvent avoir avantageusement la même section transversale mais être centrés sur des axes distincts et parallèles entre eux (parallèle à l'axe Z). Dans l'exemple de la figure 9, l'axe du deuxième micro-tube 310-p₂ d'un ensemble optique 50-n est décalé selon l'axe X de l'axe du premier micro-tube micro-tubes 310-p₁ du même ensemble optique.

Similairement à un substrat intermédiaire 320, une unité de transfert 340 du composant d'interconnexion 300 peut être adaptée pour assurer la transmission de signaux (optiques et/ou électro-optiques), entre des micro-tubes distincts 310 d'un même ensemble optique 50-n.

Une unité de transfert 340 peut comprendre une pluralité de canaux de communications 350-n correspondant à un réseau planaire ou quasi-planaire de guides d'onde optique et/ou électro-optique s'étendant par exemple sensiblement dans le plan (X,Y). Une unité de transfert 340 peut être par exemple un interposeur photonique intégré ou un PIC (acronyme pour l'expression anglo-saxonne *'Photonic Integrated Component'* signifiant 'composant photonique intégré'), correspondant à un substrat comprenant une pluralité d'éléments optiques, un ou plusieurs de ces éléments étant associé(s) à une fonction photonique. Chaque ensemble de communication 50-n est associé à un canal de communication 350-n de l'unité de transfert.

Dans des modes de réalisation, un canal de communication 350-n de propagation de signal dans l'unité de transfert 340 peut être caractérisé par un guide d'onde optique 352-n et présenter deux extrémités 354-n. Une extrémité 354-n d'un canal de communication 350-n peut être, par exemple et sans limitation, une lentille intégrée, ou encore un réseau de transmission de signal entre le guide d'onde 352-n caractérisant le canal de communication et un micro-tube 310-p₁ ou 310-p₂ de l'ensemble optique 50-n associé. De tels réseaux de transmission 354-n peuvent être des réseaux de Bragg par exemple, adapté pour modifier la direction de propagation de la composante optique d'un signal, notamment en transformant la direction de propagation selon un axe sensiblement parallèle à l'axe Z en une direction de propagation selon un axe dans le plan (X,Y).

Dans l'exemple de la figure 9, au niveau de ses extrémités, le premier micro-tube 310-p₁ est, d'une part, connecté à la zone d'émission 102-n (sur la face d'émission 104), et, d'autre part, connecté à la face 342 de l'unité de transfert 340, c'est-à-dire connecté optiquement au regard d'une extrémité 354-n d'un canal de communication 350-n. Au niveau de ses extrémités, le deuxième micro-tube 310-p₂ est, d'une part, connecté à la face 342 de l'unité de transfert 340, c'est-à-dire connecté optiquement au regard d'une autre extrémité 354-n d'un canal de communication 350-n, et, d'autre part, connecté à la zone de réception 202-n (face de réception 204) du dispositif de transmission 10.

Ainsi, un micro-tube 310 d'un ensemble optique 50-n du composant d'interconnexion 300 peut s'étendre longitudinalement entre le composant émetteur 100 et l'unité de transfert 340, et un autre micro-tube du même ensemble optique 50-n du composant d'interconnexion 300 peut s'étendre longitudinalement entre l'unité de transfert 340 et le composant récepteur 200 pour coupler optiquement la zone d'émission 102-n à la zone de réception 202-m correspondante de l'ensemble optique 50-n.

Dans des modes de réalisation, un interposeur photonique peut être équipé de micro-vias (TSV ou TGV) pour répondre à des besoins spécifiques de transmissions complexes entre les composants émetteurs et récepteurs, comme dans le cas de transmissions de signaux électriques ou de signaux optiques de polarisation.

Dans d'autres modes de réalisation, un composant d'interconnexion 300 peut comprendre une pluralité de micro-tubes 310, au moins un substrat intermédiaire 320 et/ou au moins une unité de transfert 340. Par exemple et sans limitation, le composant d'interconnexion 300 peut comprendre au moins un premier ensemble de micro-tubes 310 s'étendant longitudinalement entre le composant émetteur 100 et l'unité de transfert 340, et au moins deux autres ensembles de micro-tubes 310 s'étendant respectivement :
- entre l'unité de transfert 340 et le substrat intermédiaire 320, et
- entre le substrat intermédiaire 320 et le composant récepteur 200.

Dans les modes de réalisation où le composant d'interconnexion 300 comprend au moins un micro-tube 310 et une unité de transfert 340, le composant d'interconnexion 300 peut également comprendre un substrat de connexion. Le substrat de connexion (non représenté sur les figures) peut avoir des caractéristiques similaires au substrat intermédiaire 320 précédemment décrit et peut comprendre en particulier au moins un micro-via. Le substrat de connexion peut être agencé entre l'unité de transfert 340 et le composant récepteur 200. Par exemple et sans limitation, chaque ensemble optique 50-n du composant d'interconnexion 300 peut comprendre au moins un micro-tube 310 s'étendant longitudinalement (selon l'axe Z) entre le composant émetteur 100 et le composant récepteur 200, via l'unité de transfert 340 et le substrat de connexion (placé entre l'unité de transfert 340 et le composant récepteur 200). Une extrémité du micro-via du substrat de connexion peut être reliée optiquement à une extrémité d'un canal de communication de l'unité de transfert 340 (connecté à la face 343), tandis que l'autre extrémité du micro-via du substrat de connexion peut être connectée à une zone de réception 202-n (face de réception 204) du dispositif de transmission 10. En d'autres termes, le composant d'interconnexion 300 peut comprendre au moins un micro-via s'étendant longitudinalement entre l'unité de transfert 340 et le composant récepteur 200.

Dans des modes de réalisation, le nombre N de zones d'émission du composant émetteur 100 peut être différente de la valeur du nombre M de zones de réception du composant récepteur 200 (mode de réalisation non représenté sur les figures). Par exemple, un substrat intermédiaire 320 ou une unité de transfert 340 du composant d'interconnexion 300 peut comprendre un ou plusieurs éléments optiques auxiliaires pour :
- diviser un chemin (ou voie) optique en deux ou plusieurs chemins optiques, ou
- combiner deux ou plusieurs chemins optiques en un seul chemin optique.

De tels éléments optiques auxiliaires peuvent être passifs ou actifs et dans ce cas peuvent alimenter et/ou piloter à partir d'un signal d'alimentation électrique (i.e. courant électrique) issu d'une zone d'émission 102-n. Un élément optique auxiliaire peut correspondre par exemple à un sélectionneur optique ou un recombineur optique.

La fabrication du dispositif de transmission 10 peut être mise en œuvre à partir de toutes technologies et d'outils adaptés pour former les éléments composant le dispositif de transmission 10 dont les dimensions sont à l'échelle micrométrique et nanométrique. Les technologies utilisées pour fabriquer ces structures peuvent être des technologies de production des circuits intégrés. En particulier, la fabrication du dispositif de transmission 10 peut être mise en œuvre à partir d'un procédé comprenant une phase de conception et une phase de fabrication matérielle du dispositif de transmission 10.

La phase de conception du dispositif de transmission 10 peut comprendre un ensemble d'étapes permettant de répondre à une analyse de simulations électro-optiques et/ou du besoin du système utilisant le dispositif de transmission 10 (qui peut être par exemple un système émetteur-récepteur ou un système de conversion de signaux optiques). La phase de conception du dispositif de transmission 10 peut être mise en œuvre par ordinateur. Par exemple, la phase de conception du dispositif de transmission 10 peut être mise en œuvre via des logiciels de simulation et d'optimisation des signaux optiques transitant dans des guides d'ondes et des interposeurs photoniques.

La phase de fabrication matérielle du dispositif de transmission 10 prend en compte les résultats de la phase de conception préalablement mise en œuvre.

La figure 10 est un organigramme représentant des étapes de la phase de fabrication du dispositif de transmission 10, selon des modes de réalisation de l'invention.

Dans les étapes 1200 et 1400, le composant émetteur 100 et le composant récepteur sont fabriqués (ou préparés ou assemblés) séparément.

A l'étape 1600, le composant d'interconnexion 300 est fabriqué de manière à comprendre au moins un micro-tube 310.

A l'étape 1800, le composant émetteur 100 et le composant récepteur 200 sont assemblés, via le composant d'interconnexion 300, ce qui fournit un dispositif de transmission 10 initial.

En particulier, l'étape d'assemblage 1800 pour former le dispositif de transmission 10 peut être effectuée dans une enceinte sous vide ou sous atmosphère contrôlée, de sorte que le milieu ambiant 40 du dispositif 10 soit un milieu sous vide, ou un milieu gazeux tel que l'air ou un gaz neutre comme l'azote ou l'argon.

A l'étape 2000, le dispositif de transmission 10 fabriqué peut ensuite être inséré dans un système émetteur-récepteur ou dans un système de conversion de signaux optiques, en fonction de l'application de l'invention. En particulier, l'étape 2000 peut comprendre une sous-étape consistant à découper au moins une partie du dispositif initial afin d'obtenir un dispositif d'application comprenant un nombre d'ensembles optiques 50-n souhaité.

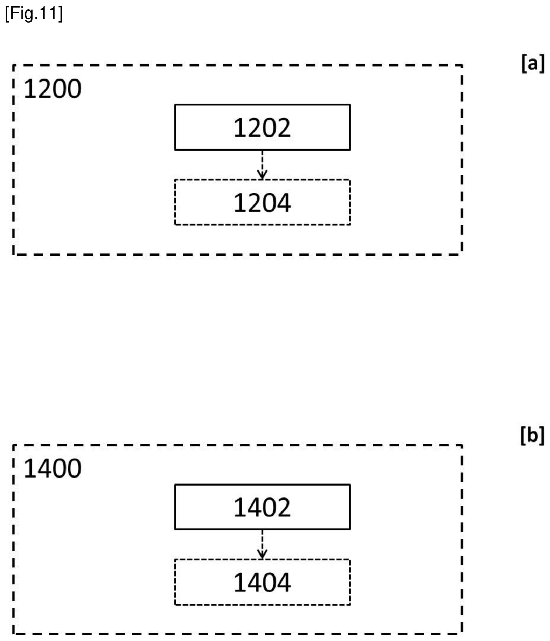

Les schémas 11[a] et 11[b] de la figure 11 sont des organigrammes représentant des exemples de sous-étapes des étapes 1200 et 1400 de préparation (ou de fabrication ou d'assemblage) du composant émetteur 100 et du composant récepteur 200 respectivement, dans la phase de fabrication matérielle du dispositif de transmission 10, selon des modes de réalisation de l'invention.

La préparation du composant émetteur 100 dans la phase de fabrication matérielle peut comprendre une sous-étape initiale 1202 consistant à préparer, assembler ou fournir un substrat émissif équipé d'une multitude de sources de lumière (i.e. zones d'émission), intégrées ou reportées.

Similairement, la préparation d'un composant récepteur 200 dans la phase de fabrication matérielle peut comprendre une sous-étape initiale 1402 consistant à préparer, assembler ou fournir un substrat récepteur équipé d'une multitude d'unités d'acquisition de lumière (i.e. zones de réception), intégrées ou reportées.

Par exemple et sans limitation, de telles sous-étapes initiales 1202 et 1402 peuvent être effectuées en utilisant des technologies de packaging adaptées, telles que des procédés « pick and place », « mass Transfer », de « laminage », et/ou de collage direct, tel que du collage 'puce sur puce', 'puce sur wafer' ou 'wafer sur wafer'.

Dans certains modes de réalisation, la phase de fabrication matérielle peut comprendre une sous-étape 1204 d'assemblage du composant émetteur 100 et/ou une sous-étape 1404 d'assemblage du composant récepteur 200, consistant à déposer des éléments de raccord, respectivement 116-n et 216-n. Ces éléments de raccord peuvent être déposés sur la face d'émission 104 du composant émetteur 100 dans le prolongement de chacune des zones d'émission 102-n, ou sur la face de réception 204 du composant récepteur 200 dans le prolongement de chacune des zones de réception 202-n.

Avantageusement, comme représenté sur les schémas des figures 2 et 3, les éléments de raccord 116-n et 216-n peuvent être des métallisations circulaires de type « donut » de configuration analogue aux micro-tubes 310 du composant d'interconnexion 300. La taille et l'épaisseur des éléments de raccord, suite aux sous-étapes 1204 et 1404, correspondant aux grandeurs hᵢ et eᵢ, peuvent alors être compris entre quelques nanomètres et plusieurs micromètres. Par exemple, la taille et l'épaisseur peuvent être égales à 2µm et 0.2µm respectivement. Les éléments de raccord 116-n et 216-n peuvent correspondre à des plots d'accueils pour les micro-tubes 310 associés. Ces métallisations peuvent être constituées d'or, d'indium, d'aluminium et en général de tout matériau suffisamment conducteur électrique et adapté aux techniques de dépôts et de gravures utilisés en microélectronique.

Dans des modes de réalisation, la taille hᵢ et l'épaisseur eᵢ des éléments de raccord 116-n et 216-n peuvent être définies en fonction de la grandeur de section g₃₁ d'un micro-tube 310-n associé et/ou de la distance de séparation d_{(n, n+1)} entre les différentes zones d'émission, entre les différentes zones de réception et/ou entre les différents micro-tubes à fabriquer.

En outre, la taille hᵢ et l'épaisseur eᵢ d'un élément de raccord peuvent également être définies en fonction de la profondeur d'insertion du micro-tube 310-n associé pour atteindre une valeur d'innocuité cible permettant de garantir une étanchéité optique et un contact électrique « zone/micro-tube », c'est-à-dire un contact électrique entre une zone considérée, 102-n ou 202-n, et un micro-tube 310-n associé.

Dans les modes de réalisation utilisant une sous-étape 1204, les micro-tubes 310 associés peuvent être préparés séparément de l'assemblage du composant émetteur 100. Similairement, dans les modes de réalisation utilisant une sous-étape 1402, les micro-tubes 310 associés peuvent être préparés séparément de l'assemblage du composant récepteur 200.

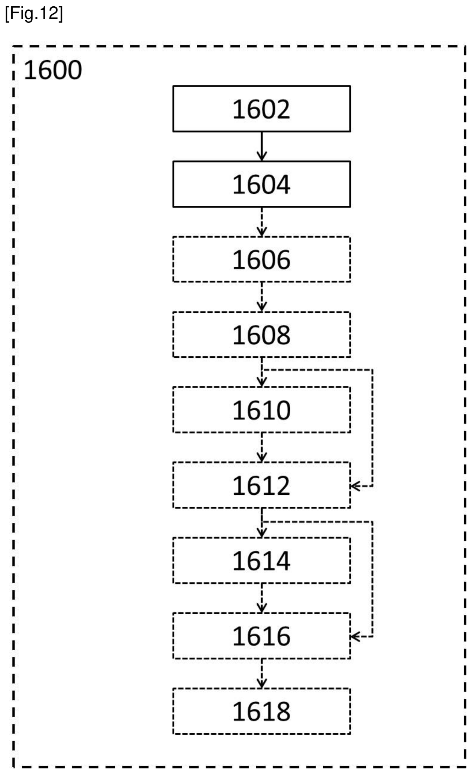

La figure 12 est un organigramme représentant l'étape 1600 d'assemblage du composant d'interconnexion 300, dans la phase de fabrication matérielle du dispositif de transmission 10, selon des modes de réalisation de l'invention.

L'assemblage du composant d'interconnexion 300 dans la phase de fabrication matérielle peut comprendre une sous-étape initiale 1602 consistant à fournir un ou plusieurs substrats supports.

Dans des modes de réalisation du procédé de fabrication du dispositif de transmission 10, un substrat support peut être le composant émetteur 100 (comme illustré sur la figure 5) ou le composant récepteur 200 préalablement assemblés, aux étapes 1200 et 1400. Un substrat support de préparation du composant d'interconnexion 300 peut également être un interposeur photonique intégré par exemple (comme illustré sur la figure 9).

Selon certains modes de réalisation, un substrat support peut être n'importe quel matériau semi-conducteur tel que, par exemple tout ou une partie d'un Wafer en Silicium, Germanium, Arséniure de gallium (AsGa), Phosphure d'indium (InP), Silicium cristallin, ou autres. Un substrat support peut en outre être formé à partir de n'importe quel matériau non semi-conducteur tel que par exemple du verre, du saphir, ou des céramiques. Un tel substrat support peut avoir une structure sensiblement plane, et s'étendre généralement dans le plan (X,Y). Par exemple et sans limitation, un Wafer peut avoir typiquement une épaisseur de 525µm et un diamètre 100mm. Le substrat support peut avoir une épaisseur de 725µm et un diamètre 200mm, ou une épaisseur de 775µm et un diamètre 300mm.

II est à noter qu'à la sous-étape initiale 1602, un substrat support formé par un Wafer peut être caractérisé par une première face (également appelée 'face de support') et une deuxième face (également appelée 'face arrière') opposée à la première face. Les première et deuxième faces peuvent être sensiblement parallèles entre elles, définies dans le plan (X,Y). Le substrat support peut avoir des formes géométriques et des dimensions variables dans le plan (X,Y).

A la sous-étape 1604 d'assemblage du composant d'interconnexion 300, pour chaque substrat support fourni, des micro-tubes 310 sont fabriqués sur une face spécifique du substrat support. Par exemple et sans limitation, la confection des micro-tubes en configuration de réseau peut être mise en œuvre à partir d'une succession d'étapes de photolithographie, de dépôt et/ou de gravures.

L'utilisation de technologies de microélectronique adaptées, telles que les techniques VLSI (acronyme pour l'expression anglo-saxonne *Very Large Scale Integration*), permet de garantir la formation d'un nombre de micro-tubes en parallèle allant jusqu'à plusieurs millions, sur une surface de quelques centimètres carrés. Le niveau de densification choisi des micro-tubes n'est a priori limité que par la distance de séparation minimale entre zones d'émission et/ou de réception, et n'est donc limité que par le type et la miniaturisation techniques des sources et des récepteurs. Une grande densité de micro-tubes permet d'obtenir une transmission de signaux optiques également en grande densité.

Dans les modes de réalisation où un substrat support est le composant émetteur 100, chaque micro-tube peut être produit sur la face d'émission 104 au regard d'une zone d'émission 102-n associée. Similairement, dans les modes de réalisation où un substrat support est le composant récepteur 200, chaque micro-tube peut être produit sur la face de réception 204 au regard d'une zone de réception 202-n associée. Dans ces cas spécifiques, en résultat de la sous-étape 1604, au moins une partie du composant d'interconnexion 300 peut être directement reliée au composant émetteur 100 ou au composant récepteur 200 respectivement.

Dans les modes de réalisation où un substrat support est un Wafer, les micro-tubes peuvent être produits, sur la face de support du substrat. Par ailleurs, la préparation du composant d'interconnexion 300 peut en outre comprendre une sous-étape 1606 consistant à amincir au moins un Wafer support, notamment par polissage de la face arrière du substrat, à partir de procédés connus associés à de la fabrication microélectronique. Dans ce cas, l'épaisseur résultante d'un substrat support après la sous-étape 1606 d'amincissement peut être inférieure ou égale à 100µm par exemple.

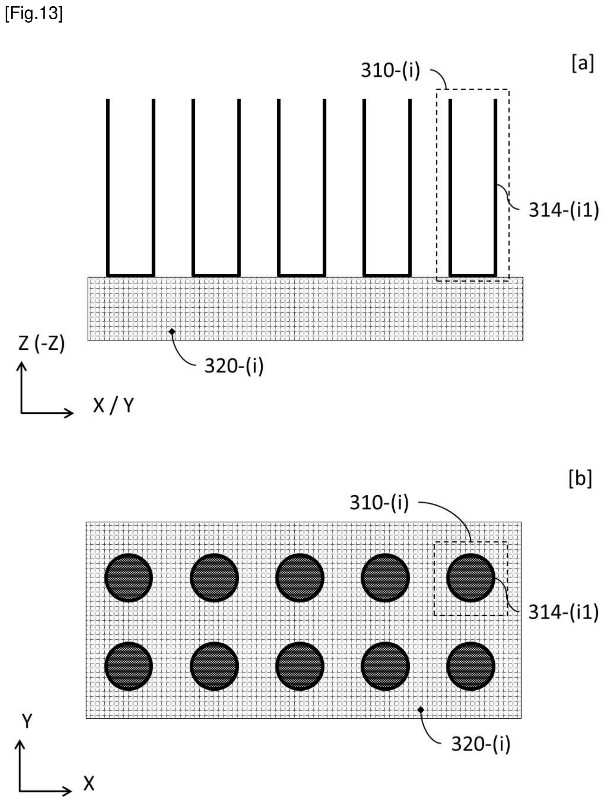

Les schémas 13[a] et 13[b] de la figure 13 représentent, dans le plan (X,Z) et le plan (X,Y) respectivement, au moins une partie du composant d'interconnexion 300 en cours de fabrication suite à la sous-étape 1604 ou à la sous-étape 1606, selon des modes de réalisation de l'invention. En particulier, les schémas 13[a] et 13[b] représentent un substrat support, désigné par la référence 320-(i), portant des micro-tubes 310-(i) en cours de fabrication (ou intermédiaires) et répartis selon une configuration matricielle. Chaque micro-tube 310-(i) peut être formé par une paroi notée 314-(i1) issue de la sous-étape 1604 de fabrication. Une paroi 314-(i1) de micro-tube peut être constituée d'une partie de matériau diélectrique, correspondant notamment à la couche 314_{A} de la paroi 314 d'un micro-tube 310-p d'un composant d'interconnexion 300 fabriqué.

Selon certains modes de réalisation, l'assemblage du composant d'interconnexion 300 peut comprendre une sous-étape initiale 1608 consistant à injecter (ou déposer) entre les micro-tubes de l'ensemble des micro-tubes 310 du composant d'interconnexion 300 un matériau de sous-enrobage (comme de l'époxy, du polyimide, ou plus généralement une résine polymère). Ce matériau de sous-enrobage peut être déposé par capillarité par exemple. Son rôle est de protéger et de fiabiliser l'assemblage.

Selon certains modes de réalisation, la préparation d'au moins une partie du composant d'interconnexion 300 peut comprendre une sous-étape 1610 consistant à effectuer un dépôt de couches métalliques de manière localisée sur l'ensemble ou une partie des micro-tubes fabriqués sur un substrat support.

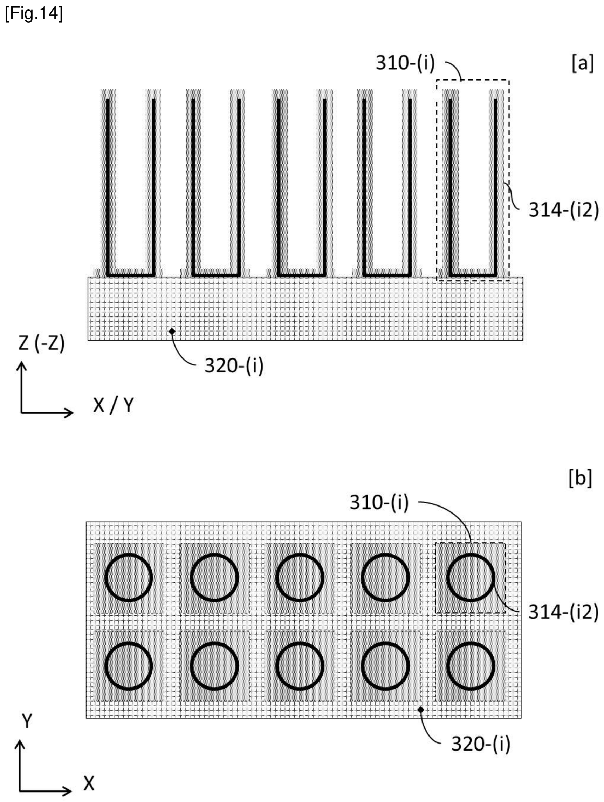

Les schémas 14[a] et 14[b] de la figure 14 représentent, dans le plan (X,Z) et le plan (X,Y) respectivement, au moins une partie du composant d'interconnexion 300 en cours de fabrication à la sous-étape 1610, selon des modes de réalisation de l'invention. En particulier, les schémas 14[a] et 14[b] représentent un substrat support 320-(i) portant des micro-tubes 310-(i) en cours de fabrication, formés chacun par une paroi 314-(i2) issue de la sous-étape 1610 de fabrication. Une paroi 314-(i2) de micro-tube peut être constituée d'une partie de matériau diélectrique recouverte d'une partie de matériau métallique, correspondant respectivement à la couche 314_{A} et aux couches 314_{B} et 314c de la paroi 314 d'un micro-tube 310-p d'un composant d'interconnexion 300 fabriqué.

Avantageusement, dans des modes de réalisation où un substrat support est un Wafer, la préparation d'au moins une partie du composant d'interconnexion 300 peut comprendre une sous-étape 1612 consistant à effectuer des gravures (ou perforations) du substrat support de façon perpendiculaire, à partir de la face arrière du substrat jusqu'à la face de support, formant une pluralité de micro-vias. Chaque gravure peut être effectuée de manière à déboucher sur l'intérieur des micro-tubes.

La sous-étape 1612 peut consister en une sous-étape de préparation du substrat intermédiaire 320 compris éventuellement dans une partie du composant d'interconnexion 300. La sous-étape 1612 peut être mise en œuvre par un procédé de microélectronique, tel que le procédé de gravure profonde du Silicium connu sous le nom de procédé BOSCH, par un procédé de gravure ionique réactive profonde (« Deep RIE »), ou encore par un procédé de gravure chimique humide dans le cas de matériaux isotropes (i.e. non cristallins).

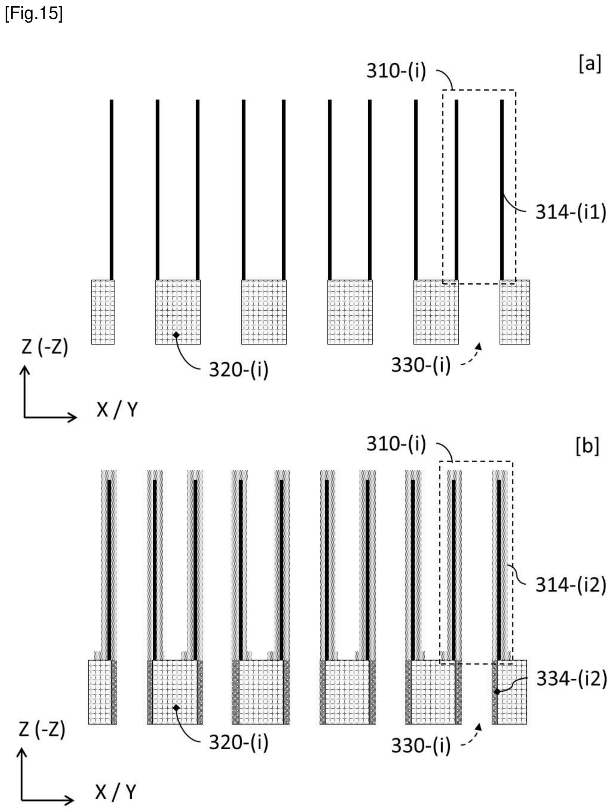

Le schéma 15[a] de la figure 15 représente, dans le plan (X,Z), au moins une partie du composant d'interconnexion 300 en cours de fabrication suite à la sous-étape 1612, selon des modes de réalisation de l'invention. En particulier, le schéma 15[a] représente un substrat support 320-(i) comprenant une pluralité de micro-vias 330-(i) et portant une pluralité de micro-tubes 310-(i) en cours de fabrication, formés chacun par une paroi 314-(i1) issue de la sous-étape 1604 de fabrication.

Avantageusement, dans des modes de réalisation où le substrat support est un Wafer, la préparation d'au moins une partie du composant d'interconnexion 300 peut comprendre une sous-étape 1614 consistant à effectuer le dépôt d'une couche mince (ou revêtement, ou *liner* en anglais) métallique sur la paroi intérieure (ou tranche, ou flanc) des micro-vias 330-(i). Une telle métallisation localisée peut être effectuée par dépôt électrochimique par exemple. Dans ces variantes de l'invention, au moins une partie des micro-tubes 310-(i) formés sur le substrat support 320-(i) peut être issue de l'étape 1610 de métallisation localisée des micro-tubes.

Le schéma 15[b] de la figure 15 représente schématiquement, dans un plan (X,Z), au moins une partie du composant d'interconnexion 300 en cours de fabrication suite à la sous-étape 1614, selon des modes de réalisation de l'invention. En particulier, le schéma 15[b] représente un substrat support 320-(i) comprenant une pluralité de micro-vias 330-(i) avec une paroi 334-(i2), et portant une pluralité de micro-tubes 310-(i) en cours de fabrication, formés chacun par une paroi 314-(i2) issue de la sous-étape 1610 de fabrication.

Avantageusement, la préparation d'au moins une partie du composant d'interconnexion 300 peut comprendre une sous-étape 1616 consistant à effectuer un remplissage (une injection) d'un matériau dans au moins une partie des micro-tubes 310-(i) et/ou des micro-vias 330-(i), d'un matériau de propagation. Par exemple et sans limitation, le remplissage peut être injecté (ou inséré) depuis la face arrière du substrat support 320-(i) formant au moins une partie du substrat intermédiaire 320. Un tel matériau d'injection peut être effectué à partir d'un poly silicium, d'un oxyde ou encore d'un nitrure notamment.

Avantageusement, une sous-étape 1616 de remplissage par un matériau dans au moins une partie des micro-tubes et/ou des micro-vias peut être effectuée à la suite d'une sous-étape 1610 et/ou d'une sous-étape 1614 de dépôt métallique sur la paroi intérieure des micro-tubes et des micro-vias. Une telle sous-étape 1616 de remplissage peut être mise en œuvre par exemple à partir d'un équipement de dépôt sous vide. Dans des exemples de réalisation, la sous-étape 1616 de remplissage peut comprendre le remplissage par un milieu liquide tel que de l'eau distillée et/ou déionisée, via le dépôt d'une micro-goutte d'eau pour former une micro-lentille. Dans ce cas, afin de maintenir l'eau dans le micro-tube pendant l'assemblage, une étape consistant à descendre en température le composant pour geler l'eau au sein du micro-tube, le temps de l'assemblage, peut être mise en œuvre.

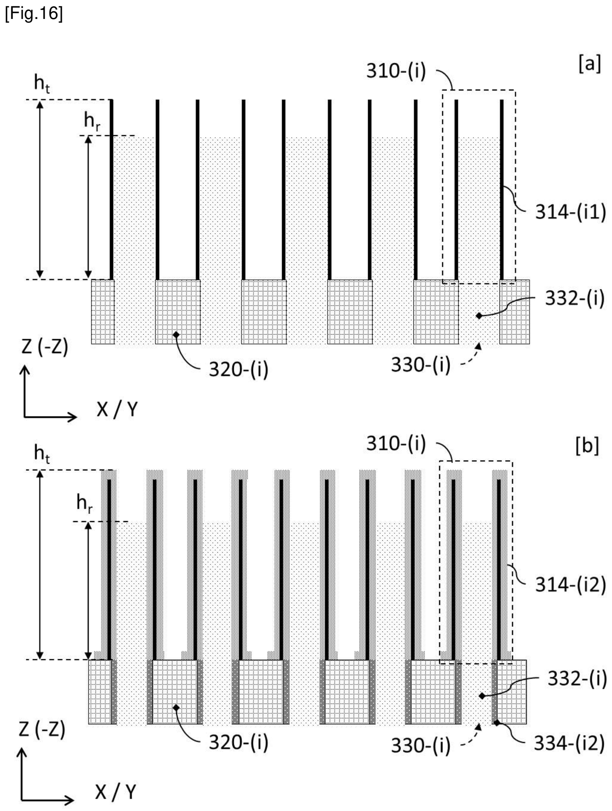

Les schémas 16[a] et 16[b] de la figure 16 représentent schématiquement, dans le plan (X,Z), au moins une partie du composant d'interconnexion 300 en cours de fabrication à la sous-étape 1616, selon des modes de réalisation de l'invention. En particulier, les schémas 16[a] et 16[b] représentent un substrat support 320-(i) comprenant une pluralité de micro-vias 330-(i) avec ou sans une paroi 334-(i2), et portant une pluralité de micro-tubes 310-(i) en cours de fabrication, chacun par une paroi 314-(i1) ou 314-(i2) issue respectivement de la sous-étape 1604 ou 1608 de fabrication. Sur les schémas 16[a] et 16[b], la pluralité de micro-vias 330-(i) et la pluralité de micro-tubes 310-(i) sont remplis d'un matériau d'injection 332-(i) résultant de la sous-étape 1616 de fabrication.

Avantageusement, dans des modes de réalisation où le procédé comprend l'utilisation de deux wafers comme substrats supports 320-(i) portant des micro-tubes 310-(i), la préparation d'au moins une partie du composant d'interconnexion 300 peut comprendre une sous-étape 1618 consistant à coller entre elles les deux faces arrières des wafers utilisés, pour former le substrat intermédiaire 320 comprenant une interface 328. Une telle opération de collage peut être mise en œuvre par brasure, ou encore avec ou sans élément d'apport. Une telle opération de collage peut notamment être mise en œuvre par collage direct oxyde, ou par collage direct métallique, ou encore par collage direct hybride (c'est-à-dire oxyde-métal). Par exemple, l'opération de collage peut être mise en œuvre via une technique du collage direct après une opération de polissage chimique et mécanique (ou CMP acronyme pour l'expression anglo-saxonne *Chemical and Mechanical Polishing*) ou après un traitement par « liaison activée en surface » (ou SAB acronyme pour l'expression anglo-saxonne *Surface Activated Bonding*).

Les étapes 1200, 1400 et/ou 1600, relatives aux différents composants fabriqués du dispositif, peuvent en outre comprendre une sous-étape consistant à découper au moins une partie du composant considéré, pour obtenir des sous-ensembles de zones d'émission, de micro-tubes et/ou de zones de réception. En particulier, de telles découpes de micro-tubes peuvent être effectuées pour former des vignettes d'au moins un micro-tube, en champs de tailles différentes pour s'adapter au nombre de guide d'onde nécessaires.

Selon certains modes de réalisation, l'étape 1800 d'assemblage des différents composants de la phase de fabrication du dispositif de transmission 10 peut consister à effectuer une insertion à froid des micro-tubes 310-(i) (fabriqués en cours de la fabrication du composant d'interconnexion 300) dans les éléments d'assemblage 116-n et/ou 216-n (formés en cours de la préparation des composants photoniques). Cette étape d'insertion peut être mise en œuvre à partir d'un équipement de type « pick and place » comprenant un système de presse contrôlé et un système d'alignement et de placement précis (de l'ordre du micron voire d'un ordre inférieur).

Au cours de cette étape d'insertion à froid les micro-tubes pénètrent le matériau malléable pour assurer l'étanchéité optique et le contact électrique. Il est à noter que l'injection du matériau de remplissage à la sous-étape 1616 d'assemblage du composant d'interconnexion 300 peut être appliquée de manière à ce qu'elle induise un remplissage partiel des micro-tubes 310-(i) défini selon une hauteur de remplissage hᵣ maximale strictement inférieure à la hauteur hₜ des micro-tubes considérés. Un tel remplissage partiel peut permettre notamment de laisser suffisamment de la hauteur 'libre' (hₜ - hᵣ) d'un micro-tube pour pénétrer dans les éléments d'assemblage de taille hᵢ. Ainsi, dans des modes de réalisation, une telle sous-étape 1616 de remplissage peut comprendre la mise en œuvre d'une étape de planarisation ou de polissage mécano-chimiques (appelé également CMP, acronyme pour l'expression anglo-saxonne *'Chemical Mechanical Polishing* / *Planarization*') ou encore la mise en œuvre d'une étape de gravure sélective à base de gaz réactifs.

L'utilisation conjointe des micro-tubes et des éléments de raccord, ainsi que l'étape d'insertion à froid, permettent d'optimiser le raccordement optique et éventuellement électrique entre le composant émetteur et le composant récepteur.

En outre, l'insertion à froid mise en œuvre à l'étape 1800 d'assemblage des composants peut prendre en compte une valeur de force de compression de l'ordre de quelques centièmes de grammes à quelques grammes par micro-tubes pris en compte dans l'opération de compression. Par exemple, une valeur de force de compression typique pour garantir la qualité des contacts formés par le dispositif 10 peut être d'environ 1 gramme par micro-tube si l'insertion est effectuée dans des éléments d'assemblage en aluminium, et d'environ 0,1 gramme par micro-tube si l'insertion est effectuée dans des éléments d'assemblage formé d'un matériau ductile comme l'indium.

La force totale de compression disponible ou à appliquer aux composants pour connecter (ou raccorder) tous les objets des ensembles optiques du dispositif 10 peut être déterminée en fonction du nombre de micro-tubes à insérer dans les plots d'accueil. Pour un appareil de compression comprenant un bras de force verticale pouvant appuyer à 400 Kg, l'insertion à froid de l'étape 1800 d'assemblage peut par exemple et sans limitation, assurer l'insertion de 400 000 à 4 000 000 de micro-tubes dans des éléments d'assemblage. Une telle capacité d'assemblage permet d'obtenir un dispositif 10 amélioré, et en particulier dense, en termes de nombre de canaux de transmissions optiques et/ou électro-optiques entre une matrice émissive et une matrice réceptrice.

L'homme du métier comprendra aisément que certaines étapes ou sous-étapes du procédé, notamment illustrée aux figures 10 et 12, peuvent être réalisées de manière simultanée, séquentielle, successive, indépendamment ou non, et/ou selon un ordre différent, par exemple selon un ordre défini au cours de la phase de conception du dispositif de transmission 10.

Il convient de noter que certaines caractéristiques de l'invention peuvent présenter des avantages lorsqu'elles sont considérées séparément.

Le procédé décrit précédemment selon les modes de réalisation de l'invention peut être mis en œuvre en utilisant divers éléments. En particulier, la phase de conception et/ou la phase de fabrication matérielle peuvent utiliser des moyens matériel (« hardware »), logiciel, ou une combinaison de matériel et de logiciels, notamment sous la forme de code de programme pouvant être distribué sous la forme d'un produit de programme, sous diverses formes.

L'invention n'est pas limitée aux modes de réalisation décrits ci-avant à titre d'exemple non limitatif. Elle englobe toutes les variantes de réalisation qui pourront être envisagées par l'homme du métier. L'homme du métier comprendra que l'invention n'est pas limitée aux différents composants, aux différentes configurations, ou aux différentes étapes de fabrication du dispositif de transmission décrits à titre d'exemple non limitatif. En particulier, certains modes de réalisation de l'invention peuvent être combinés.

## Revendications

1. Dispositif photonique (10) comprenant un composant émetteur (100), configuré pour émettre au moins un signal d'émission (S₁) comprenant une composante optique de signal, un composant récepteur (200), et un composant d'interconnexion (300) entre le composant émetteur (100) et le composant récepteur (200), ledit composant d'interconnexion (300) comprenant au moins un micro-tube (310) adapté pour transmettre ladite composante optique de signal issu dudit composant émetteur (100) vers ledit composant récepteur (200), ledit au moins un micro-tube (310) comprenant une paroi (314) et un milieu interne (312) adapté pour propager ladite composante optique de signal, entouré par la paroi du micro-tube, ladite paroi (314) étant adaptée pour séparer le milieu interne (312) et un milieu ambiant (40) dans lequel est plongé ledit dispositif photonique (10), ledit dispositif photonique (10) comprenant au moins un élément de raccord en émission et/ou en réception (116-n, 216-n), ledit élément de raccord étant configuré pour raccorder une extrémité d'un micro-tube (310) audit composant émetteur (100) ou audit composant récepteur (200), ledit élément de raccord étant composé d'un matériau métallique malléable.

2. Dispositif photonique (10) selon la revendication 1, dans lequel ledit au moins un signal d'émission (S₁) comprend en outre une composante électrique de signal, la paroi (314) d'un micro-tube (310) comprenant au moins une partie métallique configurée pour propager ladite composante électrique de signal issu dudit composant émetteur (100) vers ledit composant récepteur (200).

3. Dispositif photonique (10) selon l'une des revendications 1 à 2, dans lequel ledit composant d'interconnexion (300) comprend en outre un substrat intermédiaire (320) comprenant au moins un micro-via (330) en association avec chaque micro-tube (310), ledit au moins un micro-via (330) étant agencé pour transmettre la composante optique de signal issu du composant émetteur (100) vers ledit composant récepteur (200).

4. Dispositif photonique (10) selon la revendication 3, dans lequel ledit au moins un signal d'émission (S₁) comprend en outre une composante électrique de signal, et dans lequel ledit au moins un micro-via (330) comprend une paroi métallique (334) configurée pour propager ladite composante électrique de signal issu dudit composant émetteur (100) vers ledit composant récepteur (200).

5. Dispositif photonique (10) selon l'une des revendications 1 à 4, dans lequel ledit au moins un micro-tube (310) comprend un matériau de remplissage choisi de manière à optimiser la propagation de la composante optique du signal à transmettre.

6. Dispositif photonique (10) selon l'une des revendications 3 à 5, dans lequel ledit au moins un micro-via (330) comprend un matériau de remplissage choisi de manière à optimiser la propagation de la composante optique du signal à transmettre.

7. Dispositif photonique (10) selon l'une des revendications 1 à 6, dans lequel les dimensions dudit composant d'interconnexion (300) sont de l'ordre de quelques micromètres à quelques dizaines de micromètres.

8. Dispositif photonique (10) selon l'une des revendications 1 à 7, dans lequel ledit composant d'interconnexion (300) comprend en outre un interposeur photonique (340), ledit au moins un micro-tube (310) s'étendant longitudinalement entre ledit composant émetteur (100) et ledit interposeur photonique (340), et/ou entre ledit interposeur photonique (340) et ledit composant récepteur (200).

9. Procédé pour la fabrication du dispositif photonique (10) selon l'une des revendications 1 à 8, **caractérisé en ce que** le procédé comprend les étapes consistant à :
- préparer (1200) un composant émetteur (100) apte à émettre au moins un signal d'émission (S₁) comprenant une composante optique de signal, et préparer (1400) un composant récepteur (200), le composant émetteur (100) et/ou le composant récepteur (200) comprenant au moins un élément de raccord (116-n, 216-n) composé d'un matériau métallique malléable,
- fabriquer (1600) un composant d'interconnexion (300) comprenant au moins un micro-tube (310), et
- assembler (1800) ledit composant d'interconnexion (300) entre le composant émetteur (100) et le composant récepteur (200), à partir d'une insertion à froid dudit au moins un micro-tube (310) dans ledit au moins un élément de raccord (116-n, 216-n) ;
ledit procédé comprenant la fabrication dudit au moins un micro-tube, ledit au moins un micro-tube (310) étant apte à transmettre ladite composante optique de signal issu dudit composant émetteur (100) vers ledit composant récepteur (200), ledit au moins un micro-tube (310) comprenant une paroi (314) et un milieu interne (312) apte à propager ladite composante optique de signal, entourée par la paroi du micro-tube, ladite paroi (314) séparant le milieu interne (312) et un milieu ambiant (40) dans lequel est plongé ledit dispositif photonique (10).

10. Procédé selon la revendication 9, dans lequel ladite étape d'assemblage comprend le raccord du composant émetteur (100) et/ou du composant récepteur (200), avec une extrémité d'un micro-tube (310), au moyen d'au moins un élément de raccord en émission (116-n) et/ou d'au moins un élément de raccord en réception (216-n), ledit raccord comprenant une insertion à froid dudit au moins un micro-tube (310) du composant d'interconnexion (300) dans ledit au moins un élément de raccord en émission (116-n) et/ou en réception (216-n).

11. Procédé selon l'une des revendications 9 ou 10, dans lequel ladite étape de fabrication (1600) du composant d'interconnexion (300) comprend :
- la fourniture (1602) d'au moins un substrat support,
- la fabrication (1604) dudit au moins un micro-tube (310), sur une face de support dudit substrat support,
- la mise en œuvre (1612) d'au moins une gravure dudit substrat support de façon perpendiculaire pour former au moins un micro-via (330), à partir d'une face arrière dudit substrat support jusqu'à la face de support, ladite au moins une gravure étant effectuée de manière à déboucher sur l'intérieur dudit au moins un micro-tube (310).

12. Procédé selon l'une des revendications 9 à 11, dans lequel ledit au moins un signal d'émission (S₁) comprend en outre une composante électrique de signal, et dans lequel ladite étape de fabrication (1600) du composant d'interconnexion (300) comprend (1610) un dépôt d'une couche métallique sur la paroi (314) d'un micro-tube (310) de manière à ce que ladite paroi (314) comprend au moins une partie métallique apte à propager ladite composante électrique de signal issu dudit composant émetteur (100) vers ledit composant récepteur (200).
